(19) Europäisches Patentamt
European Patent Office
Office européen des brevets

(11) **EP 4 686 337 A1**

(12) **EUROPEAN PATENT APPLICATION**

(43) Date of publication:
**28.01.2026  Bulletin 2026/05**

(21) Application number: **25177510.2**

(22) Date of filing: **20.05.2025**

(51) International Patent Classification (IPC):
*H10B 41/10* (2023.01)     *H10B 41/27* (2023.01)
*H10B 41/50* (2023.01)     *H10B 43/10* (2023.01)
*H10B 43/27* (2023.01)     *H10B 43/50* (2023.01)

(52) Cooperative Patent Classification (CPC):
**H10B 43/10; H10B 41/10; H10B 41/27;
H10B 41/50; H10B 43/27; H10B 43/50**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **25.07.2024  KR 20240098933**

(71) Applicant: **Samsung Electronics Co., Ltd.
Suwon-si, Gyeonggi-do 16677 (KR)**

(72) Inventors:
• **KIM, Kang Lib
Suwon-si, Gyeonggi-do 16677 (KR)**
• **LEE, Jaeduk
Suwon-si, Gyeonggi-do 16677 (KR)**

(74) Representative: **Kuhnen & Wacker
Patent- und Rechtsanwaltsbüro PartG mbB
Prinz-Ludwig-Straße 40A
85354 Freising (DE)**

(54) **SEMICONDUCTOR DEVICES AND DATA STORAGE SYSTEMS INCLUDING THE SAME**

(57)     A semiconductor device (100) includes: a conductive layer; a stack structure including gate electrodes spaced apart from each other and sequentially stacked in a first direction (Z), in a first region (R1) and a second region (R2), a first and second separation regions (MS) penetrating through the stack structure, and extending in a second direction (X), perpendicular to the first direction (Z), and spaced apart from each other in a third direction (Y), perpendicular to the first direction (Z) and the second direction (X); channel structures (CH) respectively including a channel layer and penetrating through the stack structure in the first direction (Z), in the first region (R1); and contact plugs (MC) extending by different lengths by penetrating through at least one of the gate electrodes of the stack structure, electrically connected to each of the gate electrodes, and spaced apart from each other, in the second region (R2).

FIG. 2

EP 4 686 337 A1

**Description**

BACKGROUND

The present disclosure relates generally to semiconductor devices, and data storage systems including the same.

In a data storage system requiring data storage, a semiconductor device capable of storing a large amount of data is required. Accordingly, a method of increasing the data storage capacity of a semiconductor device has been researched. For example, as one method of increasing the data storage capacity of a semiconductor device, a semiconductor device including memory cells arranged three-dimensionally instead of memory cells arranged two-dimensionally has been proposed.

SUMMARY

An aspect of the present disclosure is to provide a semiconductor device that may be miniaturized while securing a degree of integration by minimizing an area of a region in which contact plugs connected to gate electrodes are disposed.

According to example embodiments, provided is a semiconductor device including: a conductive layer; a stack structure including gate electrodes spaced apart from each other and sequentially stacked in a first direction, perpendicular to an upper surface of the conductive layer, in a first region and a second region, adjacent to the first region; a first separation region and a second separation region penetrating through (i.e., extending in) the stack structure, along the second region from the first region, and extending in a second direction, perpendicular to the first direction, and spaced apart from each other in a third direction, perpendicular to the first direction and the second direction; channel structures respectively including a channel layer and penetrating through the stack structure in the first direction, in the first region; and contact plugs extending by different lengths by penetrating through at least one of the gate electrodes of the stack structure, electrically connected to each of the gate electrodes, and spaced apart from each other, in the second region, wherein the second region includes: a first extension region in which a distance in the third direction between the first separation region and the second separation region has a second distance greater than a first distance in the third direction between the first separation region and the second separation region in the first region; and a second extension region in which a distance in the third direction between the first separation region and the second separation region has a third distance smaller than the first distance.

According to example embodiments, provided is a semiconductor device including: a conductive layer; a stack structure including gate electrodes spaced apart from each other and sequentially stacked in a first direction, perpendicular to an upper surface of the conductive layer, in a first region and a second region, adjacent to the first region; first separation regions penetrating through the stack structure from the first region along the second region and extending in a second direction, perpendicular to the first direction, and spaced apart from each other in a third direction, perpendicular to the first direction and the second direction, to define a block group; at least one second separation region having a bend portion by penetrating through the stack structure along the second region from the first region between the first separation regions and extending in the second direction, and dividing the block group into at least two blocks; channel structures respectively including a channel layer and penetrating through the stack structure, in the first region of each of the at least two blocks, wherein each of the at least two blocks includes: contact plugs extending by different lengths by penetrating through at least one of the gate electrodes of the stack structure, electrically connected to the gate electrodes respectively, and spaced apart from each other to form rows and columns, in the second region, and each of the at least two blocks includes: a basic portion in which n contact plugs are arranged in the second direction in the second region, where n is a natural number; and an expansion portion expanded from the basic portion in the third direction, in which the number of contact plugs less than n are disposed.

According to example embodiments, provided is a data storage system including: a semiconductor storage device including a first semiconductor structure including circuit elements, a second semiconductor structure disposed on one surface of the first semiconductor structure, and an input/output pad electrically connected to the circuit elements; and a controller electrically connected to the semiconductor storage device through the input/output pad and controlling the semiconductor storage device, wherein the second semiconductor structure includes: a conductive layer; a stack structure including gate electrodes spaced apart from each other in a first direction, perpendicular to an upper surface of the conductive layer, and sequentially stacked, in a first region and a second region, adjacent to the first region; first separation regions penetrating through the stack structure, along the second region from the first region, and extending in a second direction, perpendicular to the first direction, and spaced apart from each other in a third direction, perpendicular to the first direction and the second direction, to define a block group; at least one second separation region having a bend portion by penetrating through the stack structure along the second region from the first region between the first separation regions in the block group and extending in the second direction, and dividing the block group into at least two blocks; channel structures respectively including a channel layer and penetrating through the stack structure, in the first region of each of the at least two blocks; and contact plugs extending by different lengths by penetrating through at least one of the gate electrodes of the stack structure, electrically connected to the gate electrodes respectively, and spaced apart from each other to form rows and columns, in the second region of each of the at least two blocks, wherein each of the at least two blocks includes: a basic portion in which n contact plugs are arranged in the second direction in the second region, where n is a natural number; and an expansion portion extending in the third direction from the basic portion, in which the number of contact plugs less than n are disposed.

According to example embodiments, contact plugs in contact with contact regions of gate electrodes may be formed in a contact plug forming process without an addition stepwise etching process for forming contact regions of gate electrodes in a stepwise shape. Specifically, the gate electrodes may not be etched in a stepwise shape, but the contact plugs may be formed with different lengths to connect the contact plugs to gate electrodes of different levels, thereby improving the degree of freedom of arrangement of the contact plugs.

Since the contact plugs are formed with different lengths by applying multiple etching processes, the contact plugs may be freely disposed as long as a separation distance from adjacent contact plugs is satisfied while securing the size of the contact plugs. Additionally, when the contact plugs are disposed, an example embodiment may be modified to further include contact plugs in each block by bending a separation region between adjacent blocks by adding a gap space from the separation region to a gap space of the adjacent block. Accordingly, it may be possible to arrange as many contact plugs as possible without surplus space, so that the contact plugs may be connected to gate electrodes in a high number of stack structures, thereby securing the degree of a degree of integration as well as minimizing a space of the connection region.

Advantages and effects of the present application are not limited to the foregoing content and may be more easily understood in the process of describing a specific example embodiment of the present disclosure.

BRIEF DESCRIPTION OF DRAWINGS

The above and other aspects, features, and advantages of the present disclosure will be more clearly understood from the following detailed description, taken in conjunction with the accompanying drawings, wherein like reference numerals (when used) indicate corresponding elements throughout the several views, and in which:

FIG. 1 is a schematic plan view of a semiconductor device according to example embodiments;
FIG. 2 is a partially enlarged plan view of the semiconductor device of FIG. 1;
FIGS. 3A to 3C are schematic cross-sectional views of a semiconductor device according to an example embodiment;
FIGS. 4A to 4C are enlarged views of partial regions of FIGS. 3A to 3C;
FIGS. 5 to 10 are enlarged cross-sectional views schematically illustrating a semiconductor device according to example embodiments;
FIG. 11 is a schematic cross-sectional view of a semiconductor device according to an example embodiment;
FIG. 12 is a flowchart illustrating a process of forming a semiconductor device according to example embodiments;
FIGS. 13A to 13J are schematic cross-sectional views illustrating intermediate processes in a method of manufacturing a semiconductor device according to example embodiments;
FIG. 14 is a diagram schematically illustrating a data storage system including a semiconductor device according to example embodiments; and
FIG. 15 is a perspective view schematically illustrating a data storage system including a semiconductor device according to an example embodiment.

DETAILED DESCRIPTION

Hereinafter, example embodiments of the present disclosure will be described with reference to the accompanying drawings. Hereinafter, it may be understood that relative expressions such as "on," "above," "upper," "below," "beneath," "lower," and "side," merely indicate positions of elements and/or structures with respect to other elements and/or structures, as shown in the drawings, and are not intended to convey an absolute position of the particular elements and/or structures.

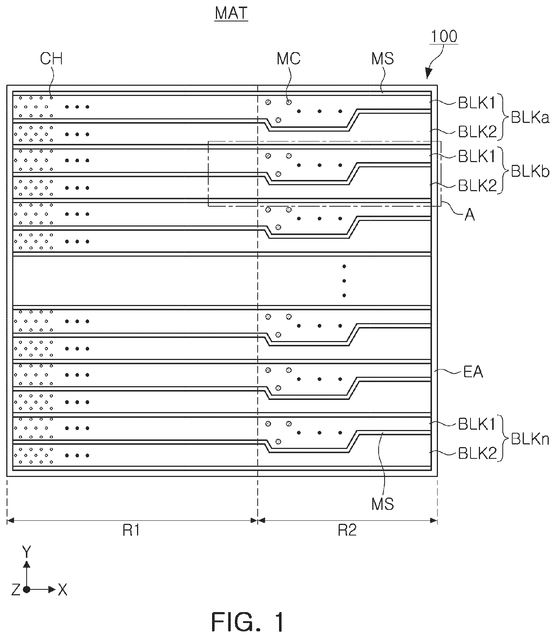

Hereinafter, a semiconductor device according to an example embodiment will be described with reference to FIGS. 1 to 4C.

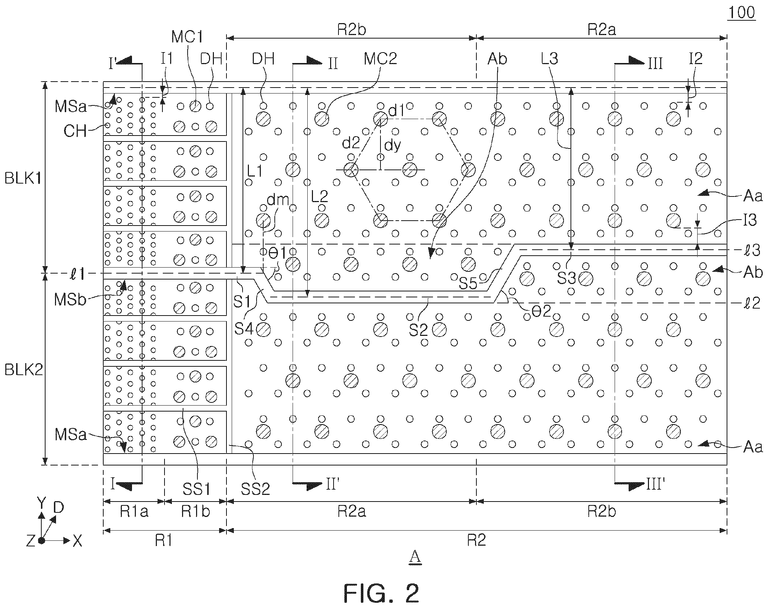

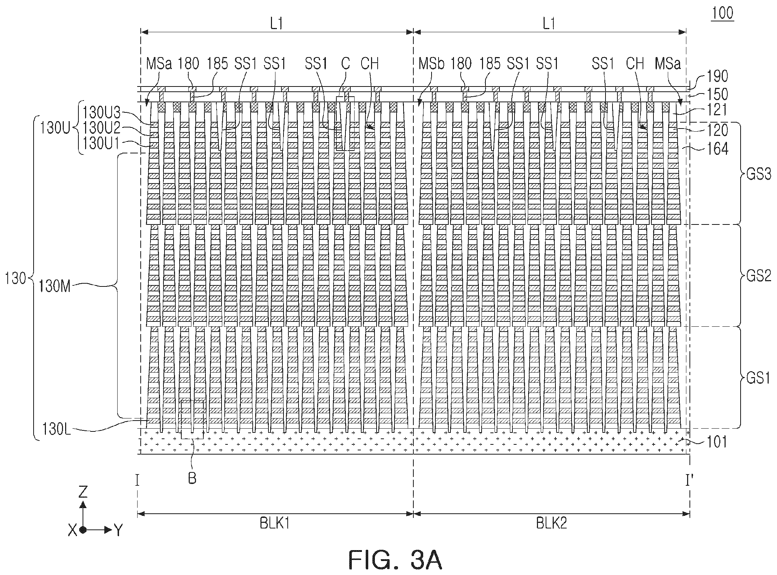

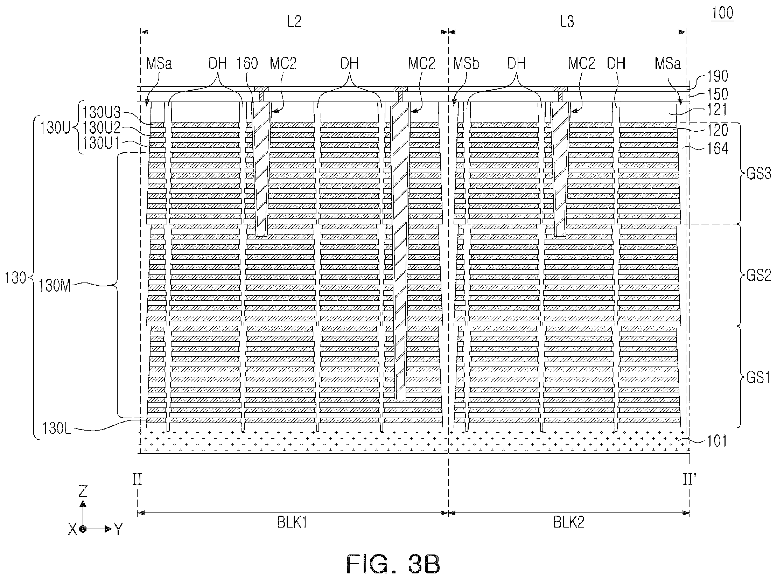

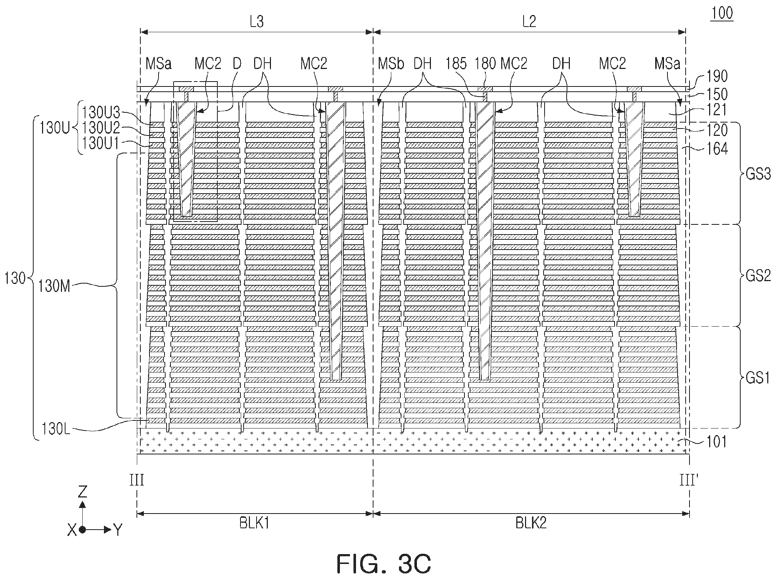

FIG. 1 is a schematic plan view of a semiconductor device according to example embodiments, FIG. 2 is an enlarged plan view of region 'A' of the semiconductor device of FIG. 1. FIGS. 3A to 3C are schematic cross-sectional views of a semiconductor device according to an example embodiment, FIG. 3A is a cross-sectional view illustrating a region taken along line I-I' of the semiconductor device of FIG. 2, FIG. 3B is a cross-sectional view illustrating a region taken along line II-II' of the semiconductor device of FIG. 2, and FIG. 3c is a cross-sectional view illustrating a region taken along line III-III' of the semiconductor device of FIG. 2.

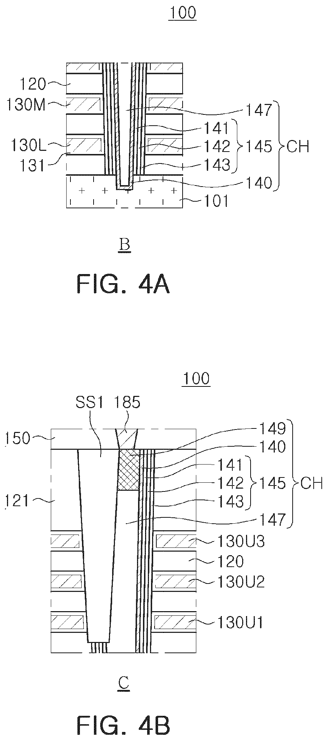

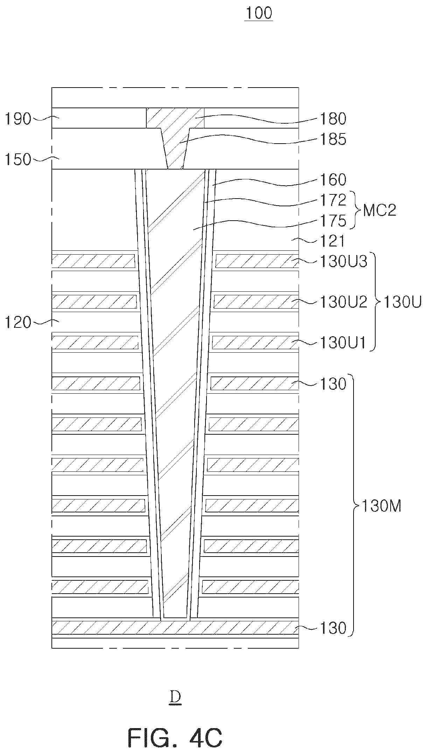

FIGS. 4A to 4C are enlarged views of some regions of FIGS. 3A to 3C, and FIG. 4A illustrates region 'B' of FIG. 3A, FIG. 4B illustrates region 'C' of FIG. 3A, and FIG. 4C illustrates region 'D' of FIG. 3C.

Referring to FIG. 1, a semiconductor device 100 may be implemented as a mat MAT unit, and at least one mat MAT may be arranged in various forms to form one semiconductor device 100.

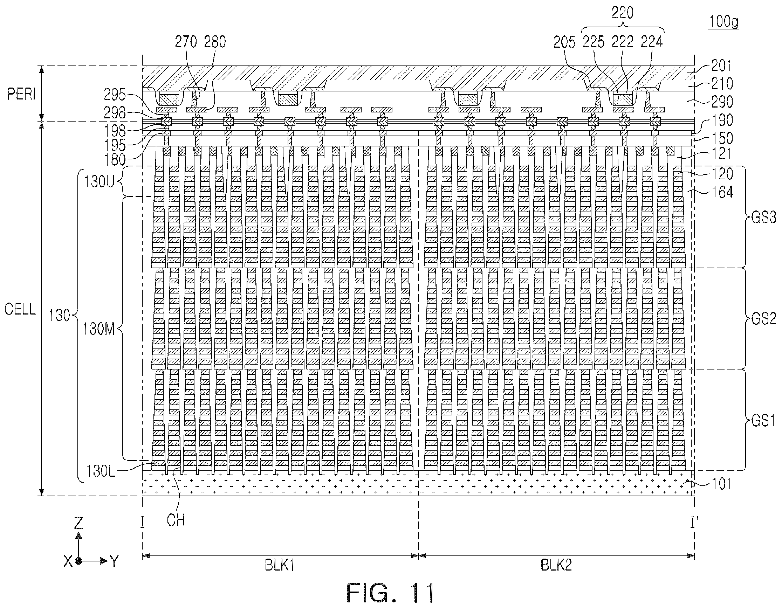

A cell region R1 and an extension region R2 may be included in the mat MAT in an X-direction. The cell region R1 is a memory cell region in which memory cells are disposed, and may be a region in which channel structures CH are disposed, and the extension region R2 may correspond to a region for electrically connecting the memory cells to peripheral circuit structures PERI (see FIG. 11), and may be a region in which contact plugs MC connected to gate electrodes 130 (see, e.g., FIG. 3A) are disposed for this purpose, but the present disclosure is not limited thereto.

An edge area EA may be disposed on each side of the mat MAT. The edge area EA may be disposed on the outside of the extension region R2 and the outside of the cell region R1, and may be a region in which a mold structure remains. The edge area EA may be defined as a region in which a pad region connected from the outside is disposed, external contact vias connected to the pad region are disposed, or various through-vias of semiconductor devices are disposed. The edge area EA may be disposed on each side of the mat MAT to have a frame shape, but the present disclosure is not limited thereto.

In the mat MAT, a plurality of separation regions MS may be disposed by intersecting the cell region R1 and adjacent extension region R2 in the X-direction.

As the separation regions MS are structures extending in the X-direction and spaced apart from each other in a Y-direction, a gap between one separation region MS and an adjacent separation region MS in the Y-direction may be defined as blocks BLK1 and BLK2, respectively. The blocks BLK1 and BLK2 may be regarded as a reference unit for operation, and one block BLK1 or BLK2 may be insulated from an adjacent block BLK1 or BLK2 by the separation regions MS, so that the contact plugs MC may be respectively disposed in the extension regions R2 of each block BLK1 and BLK2.

The semiconductor device 100 may include a plurality of block groups BLKa to BLKn including at least two adjacent blocks BLK1 and BLK2 in the mat MAT. Each of the block groups BLKa to BLKn may include the same number of blocks BLK1 and BLK2, and the separation regions MS may also be disposed between the block groups BLKa to BLKn. The separation regions MS between the block groups BLKa to BLKn may not be bent (i.e., straight) and may extend in the X-direction, and may be parallel to each other.

The separation regions MS disposed between multiple blocks BLK1 and BLK2 in one block group BLKa to BLKn may extend in a straight line in a portion passing through the cell region R1, and may have a portion bent in the extension region R2.

In this manner, the separation region MS between one extension region R2 and the adjacent extension region R2 may be bent, so that the blocks BLK1 and BLK2 in which areas of the extension regions R2 of the adjacent blocks BLK1 and BLK2 are redistributed may form one block group BLKa to BLKn.

The number of blocks BLK1 and BLK2 included in each block group BLKa to BLKn may be all the same, and a shape of one block group BLKa to BLKn in one mat MAT may be substantially the same as a shape of another block group BLKa to BLKn. That is, substantially identical block groups BLKa to BLKn may be successively arranged in the Y-direction. In contrast, an arrangement of blocks BLK1 and BLK2 in one block group BLKa to BLKn may be mirror-symmetrical with an arrangement of blocks BLK1 and BLK2 in the adjacent block group BLKa to BLKn.

Referring to FIGS. 2 to 4C, one block group BLKb among the block groups BLKa to BLKn is illustrated, and the semiconductor device 100 may include two blocks BLK1 and BLK2 in one block group BLKb.

Each of the blocks BLK1 and BLK2 may include a cell region R1 and an extension region R2, respectively. Each block BLK may include a cell region R1 and an extension region R2 on one side of the cell region R1 in the X-direction.

The cell region R1 is a memory cell region in which memory cell strings are disposed, and may be a region in which channel structures CH are disposed. The extension region R2 may be a region in which a plurality of word line contact plugs MC2 (see FIG. 3C) connected to gate electrodes 130 on different levels are disposed.

The cell region R1 may include a memory region R1a in which the channel structures CH are disposed, and a string selection region R1b between the memory region R1a and the extension region R2. The string selection region R1b may be defined as a region in which string selection contact plugs MC1 for selecting gate electrodes 130, which are string selection lines, are disposed. Substantially, the memory region R1a may occupy most of the area of the cell region R1, but, in terms of the division of the gate electrodes 130, since the string selection contact plugs MC1 of the string selection regions R1b operate the channel structure CH partitioned together, the string selection regions R1b may be described together in the cell region R1. Accordingly, the semiconductor device 100 may have a structure in which the memory region R1a, the string selection region R1b, and the extension region R2 are successively arranged in the X-direction, in each of the blocks BLK1 and BLK2.

The semiconductor device 100 may include a conductive layer 101 in the cell region R1 and the extension region R2, stack structures GS (GS1 to GSk where k is 1, 2, 3..., positive integer) in which the gate electrodes 130 and interlayer insulating layers 120 are alternately stacked on an upper surface of the conductive layer 101 in a Z-direction, channel structures CH disposed in the cell region R1 so as to penetrate through (i.e., extend in) stack structures GS1 to GSk, separation regions MS extending in the X-direction by penetrating through the stack structures GS1 to GSk, and insulating regions SS penetrating through a portion of the gate electrodes 130. An interconnection structure and a passivation layer may be further included below the conductive layer 101.

Support structures DH and word line contact plugs MC2 may be disposed in the extension region R2, and the support structures DH and the string selection contact plugs MC1 may be disposed in the string selection region R1b.

In FIGS. 3B to 3C, contact plugs MC1 and MC2 are illustrated as extending by different lengths, for the purpose of connection between each gate electrode 130 and the contact plugs MC1 and MC2, but the present disclosure is not limited thereto.

The cell region R1 and the extension region R2 may include a cell region insulating layer 150 in an upper portion of the stack structures GS1 to GSk, may include studs 185 penetrating through the cell region insulating layer 150, and configured for electrical connection with the channel structure CH and the contact plugs MC1 and MC2, and cell interconnection lines 180 in an upper portion of the cell region insulating layer 150 (and/or e.g. in an upper insulating layer 190).

The conductive layer 101 is a common source line, and may include at least one of a conductive material such as doped silicon or a conductive material such as a metal or a metal nitride. For example, the conductive layer 101 may include a silicon layer having an N-type conductivity that may be a common source.

The gate electrodes 130 may be vertically spaced apart from each other and stacked on the upper surface of the conductive layer 101 and may thus form a stack structure GS (GS1 to GSk) along with the interlayer insulating layers 120. The gate electrodes 130 may extend in the Y-direction from the extension region R2 to the cell region R1 on one side, but upper gate electrodes 130U may be physically and electrically separated between the string selection region R1b and the extension region R2.

The stack structures GS1 to GSk may include vertically stacked multiple-stage stack structures GS1 to GSk. In FIGS. 3A and 3C, first to third stack structures GS1, GS2 and GS3 are illustrated as being included, but the present disclosure is not limited thereto. According to example embodiments, the stack structures GS1 to GSk may be formed of two-stage stack structures GS1 and GS2.

In the stack structures GS1 to GSk, the gate electrodes 130 and the interlayer insulating layers 120 may be alternately stacked in a Z-direction (i.e., vertically), and a boundary surface between the stack structures GS1 to GSk may be defined as an interface between an uppermost gate electrode 130 of the stack structures GS1 to GSk disposed below and a lowermost interlayer insulating layer 120 of the stack structure GS2 and GS3 disposed above. Thicknesses, in the Z-direction, of the lowermost interlayer insulating layer 120 and the uppermost gate electrode 130 disposed on the boundary surface may be substantially the same as a thickness of the other interlayer insulating layers 120. A length of each stack structures GS1 to GSk in the Z-direction and the number of gate electrodes 130 may be the same, but the present disclosure is not limited thereto.

For the entire stack structures GS1 to GSk, the gate electrodes 130 may include at least one lower gate electrode 130L included in a gate of a ground selection transistor, memory gate electrodes 130M included in a plurality of memory cells, and upper gate electrodes 130U forming string select lines included in gates of string select transistors. Here, the lower gate electrode 130L and the upper gate electrodes 130U may be referred to as "lower" and "upper" based on a direction during a manufacturing process. The number of memory gate electrodes 130M included in memory cells may be determined according to the storage capacity of the semiconductor device 100. According to example embodiments, the number of upper and lower gate electrodes 130U and 130L may be one, two, or more, and the upper and lower gate electrodes 130U and 130L may have a structure identical to or different from the memory gate electrodes 130M. In an example embodiment, the number of the upper gate electrodes 130U may be illustrated as being three. Erase gate electrodes 130 may be further disposed below the upper gate electrodes 130U. Additionally, some of the gate electrodes 130, for example, the memory gate electrodes 130M adjacent to the upper or lower gate electrodes 130U and 130L may be dummy gate electrodes 130, but the present disclosure is not limited thereto.

Referring to FIGS. 2 to 4C, the gate electrodes 130 may be physically and electrically separated from each other in the Y-direction, by the separation regions MS extending continuously from the cell region R1 to the extension region R2. An area of the gate electrodes 130 between two adjacent separation regions MS may be defined as an area of one block BLK1 or BLK2.

Some of the gate electrodes 130, for example, the memory gate electrodes 130M, may not be separated in one block BLK1 or BLK2 and may each form one layer (plate). The gate electrodes 130 may be vertically spaced apart from each other and stacked in the memory region R1a, the string selection region R1b, and the extension region R2, and may maintain a continuous plate shape without forming a staircase-shaped stepped structure in the extension region R2. Contact regions of each of the gate electrodes 130 may be defined as regions in contact with the contact plugs MC1 and MC2 in the string selection region R1b and the extension region R2.

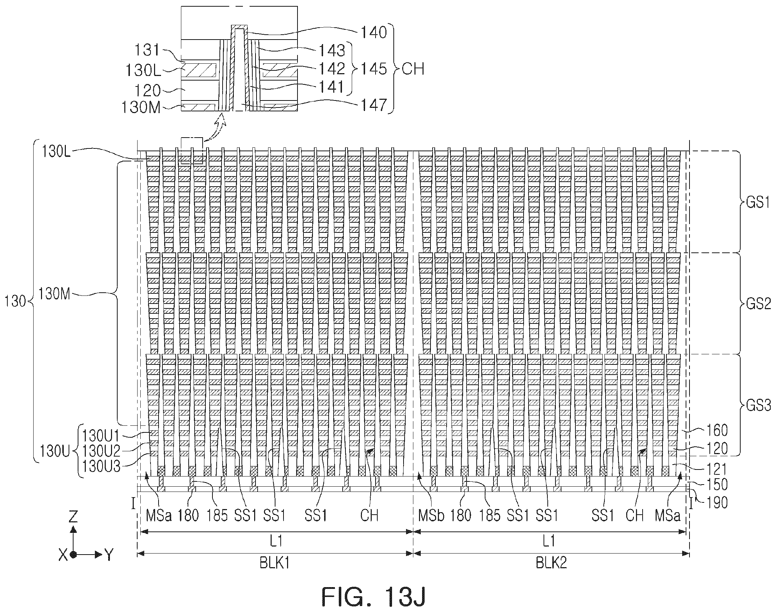

The gate electrodes 130 may be formed of, for example, tungsten (W), ruthenium (Ru), molybdenum (Mo), niobium (Nb), nickel (Ni), cobalt (Co), titanium (Ti), tantalum (Ta), titanium nitride (TiN), tantalum nitride (TaN), tungsten nitride (WN), niobium nitride (NbN), titanium aluminide (TiAl), titanium aluminum nitride (TiAlN), titanium silicide (TiSi), titanium silicon nitride (TiSiN), tantalum silicide (TaSi), tantalum silicon nitride (TaSiN), ruthenium titanium nitride (RuTiN), nickel silicide (NiSi), cobalt silicide (CoSi), or combinations thereof, but the present disclosure is not limited thereto. According to example embodiments, the gate electrodes 130 may further include a diffusion barrier 131 (see FIG. 13J), and, for example, the diffusion barrier 131 may include tungsten nitride (WN), tantalum nitride (TaN), titanium nitride (TiN), or combinations thereof.

The interlayer insulating layers 120 may be disposed between the gate electrodes 130 and may thus be formed in the stack structures GS1, GS2 and GS3. Similarly to the gate electrodes 130, the interlayer insulating layers 120 may be spaced apart from each other in a Z-direction, perpendicular to the upper surface of the conductive layer 101 and may extend in the X-direction. The interlayer insulating layers 120 may include an insulating material such as silicon oxide or silicon nitride, although embodiments are not limited thereto.

In example embodiments, thicknesses of the interlayer insulating layers 120 may be generally the same, but some may not be the same. For example, an uppermost interlayer insulating layer 121, among the interlayer insulating layers 120, may have a greater thickness than the other interlayer insulating layers 120, but the present disclosure is not limited thereto.

The separation regions MS disposed between the respective blocks BLK1 and BLK2 may include first separation regions MSa and at least one second separation region MSb.

When two blocks BLK1 and BLK2 are arranged in one block group BLKb, the first separation regions MSa disposed in the upper and lower portions defining one block group BLKb may be disposed to extend in a straight line in the X-direction by penetrating through the gate electrodes 130 in the Z-direction. The first separation regions MSa may extend in the X-direction by continuously intersecting the cell region R1 and the extension region R2. The first separation regions MSa may be parallel to each other.

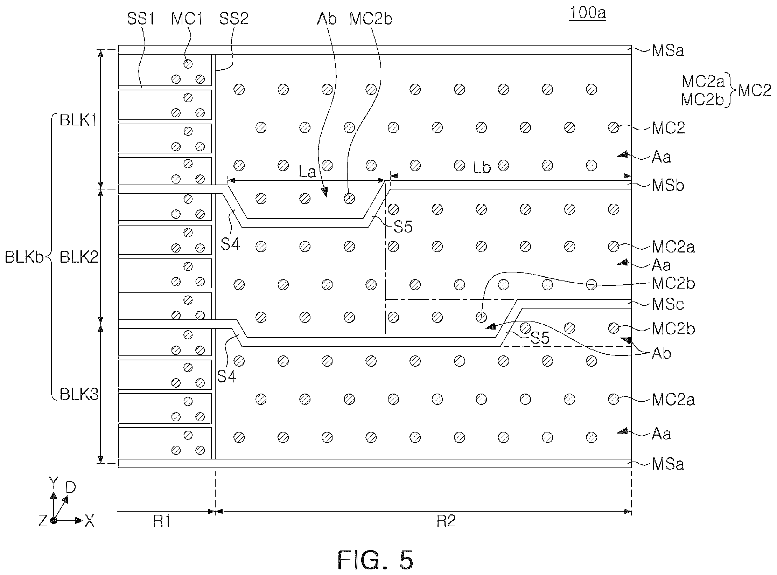

The second separation region MSb between the blocks BLK1 and BLK2 in one block group BLKb may extend in the X-direction by continuously intersecting the cell region R1 and the extension region R2, but may include at least two bend portions S4 and S5 in the extension region R2 (see, e.g., FIG. 5). By the bend portions S4 and S5, each of the blocks BLK1 and BLK2 in one block group BLKb may include the extension regions R2 respectively including a basic portion Aa and an expansion portion Ab (see, e.g., FIG. 5).

The basic portion Aa may have a length L3 of a third separation distance in a second extension region R2a and a first extension region R2b, and may be defined as a portion in which a plurality of word line contact structures MC2 of n columns are arranged in each column.

The expansion portion Ab may be defined as a portion protruding from the basic portion Aa in the Y-direction in the second extension region R2a / in the first extension region R2b and extending a length of the basic portion Aa in the Y-direction.

The second separation region MSb may include a first horizontal portion S1 extending to be parallel to the first separation regions MSa in the X-direction from the memory region R1a to the string selection region R1b, and the first horizontal portion S1 may be disposed to satisfy a first separation distance L1 from the first separation regions MSa adjacent to each other in the Y-direction. Accordingly, the stack structure GS in the cell region R1 may have a length of the first separation distance L1 in the Y-direction.

The second separation region MSb may include a second horizontal portion S2 extending to be parallel to the first separation regions MSa in the X-direction by passing through the extension region R2, and having a second separation distance L2 greater than the first separation distance L1 in the Y-direction from the first separation region MSa in an upper portion, and a third horizontal portion S3 extending to be parallel to the first separation regions MSa in the X-direction by passing through the extension region R2, and having a third separation distance L3 less than the first separation distance L1 in the Y-direction from the first separation region MSa in the upper portion. The second separation region MSb may include at least two bend portions S4 and S5 so as to connect the first to third horizontal portions S1 to S3 extending in parallel by having different separation distances from the first separation region MSa extending in parallel in the X-direction without a bend portion.

The first bend portion S4 may have a first slope θ1 to connect the first horizontal portion S1 and the second horizontal portion S2 and may be connected from the first horizontal portion S1 to the second horizontal portion S2. The second bend portion S5 may have a second slope θ2 to connect the second horizontal portion S2 and the third horizontal portion S3 and may be connected from the second horizontal portion S2 to the third horizontal portion S3. The first slope θ1 of the first bend portion S4 and the second slope θ2 of the second bend portion S5 may have slopes of the same size, but the present disclosure is not limited thereto. The first slope θ1 and the second slope θ2 may be greater than 0 and equal to or less than 90 degrees. When the first slope θ1 and the second slope θ2 are 90 degrees, the first horizontal portion S1 and the second horizontal portion S2 and the second horizontal portion S2 and the third horizontal portion S3 may be vertically bent. A length of the first bend portion S4 may be smaller than the length of the second bend portion S5.

In this manner, in the stack structure GS, the second extension region R2a having a length of a second separation distance L3 and the first extension region R2b having a length of the third separation distance L2 in the extension region R2 in the Y-direction may be successively disposed in the X-direction. Such a disposition of the extension region R2 may be subject to a symmetrical arrangement in the blocks BLK1 and BLK2 in one block group BLKb. That is, when in a first block BLK1 in one block group BLKb, the first extension region R2b having a length of the second separation distance L2 is disposed adjacently to the string selection region R1b, and the second extension region R2a having the length of the third separation distance L3 is disposed adjacently to the first extension region R2b, and in a second block BLK2 of the first extension region R2b, the second extension region R2a having the length of the third separation distance L3 may be disposed adjacently to the string selection region R1b, and the first extension region R2b having the length of the second separation distance L2 may be disposed adjacently to the second extension region R2a. In this manner, in the extension region R2 of one block BLKb, the stack structure GS may include a long portion and a short portion in the Y-direction, and in the two blocks BLK1 and BLK2 in one block group BLKb, the first extension region R2b in which a length of the first block BLK1 is long and the second extension region R2a in which a length of the second block BLK2 is short may be successively arranged in the Y-direction, and the second extension region R2a in which the length of the first block BLK1 is short may be successively arranged in the Y-direction with the first extension region R2b in which the length of the second block BLK2 is long. In one block BLK1 or BLK2, the length L2 of the first extension region R2b in the Y-direction may be greater than the length L1 of the cell region R1 in the Y-direction, and the length L3 of the second extension region R2a in the Y-direction may be less than the length L1 of the cell region R1 in the Y-direction. Such arrangement of each block BLK1 and BLK2 may be such that when one block BLK1 or BLK2 is defined as the basic portion Aa and the expansion portion Ab, the expansion portions Ab of the two blocks BLK1 and BLK2 are successively arranged in the X-direction and may be disposed to be separated from each other by the second slope S5 of the second separation region MSb. The expansion portion Ab in one block may be implemented as a plurality of expansion portions Ab spaced apart from each other, and the sum of the plurality of expansion portions Ab may be defined as the expansion portion Ab of one block BLK1 or BLK2.

A first center line l1, which is a center line of a width in the first horizontal portion S1 of the second separation region MSb (e.g., an imaginary line in the X-direction connecting centers of widths thereof), may be disposed on a level between a second center line l2, a center line of a width of the second horizontal portion S2, and a third center line 13, a center line of a width of the third horizontal portion S3. In this case, a distance (distance in the Y-direction) between the first center line l1 and the second center line l2 may be substantially the same as a distance between the first center line 11 and the third center line 13, but the present disclosure is not limited thereto.

The first and second separation regions MS may have a flat type side surface on an X-Y plane, but on the contrary, the first and second separation regions MS may have a shape having a continuous curved side surface and extending in the X-direction.

A separation insulating layer 164 may be disposed in the first and second separation regions MS. The separation insulating layer 164 may have a shape whose width decreases toward the conductive layer 101 due to a high aspect ratio, but the present disclosure is not limited thereto. An upper surface of the separation insulating layer 164 may be in contact with the cell region insulating layer 150, and a lower surface thereof may be in contact with the upper surface of the conductive layer 101.

The insulation regions SS may include first insulation regions SS1 extending in the X-direction and second insulation regions SS2 extending in the Y-direction, between the separation regions MS adjacent to each other. The insulating regions SS may selectively penetrate through only the upper gate electrodes 130U1 to 130U3, i.e., string selection lines SSL, and may divide the upper gate electrodes 130U1 to 130U3 of the stack structures GS1 to GS3 into a plurality of sub-regions.

Referring to FIG. 2, the second insulating regions SS2 may separate the upper gate electrodes 130U1 to 130U3 by intersecting the extension region R2 and the string selection region R1b in the Y-direction. When at least three upper gate electrodes 130U1 to 130U3 are assigned as string selection lines, the three upper gate electrodes 130U1 to 130U3 may be simultaneously penetrated by the second insulating regions SS2 and physically/electrically separated from each other on the plane.

The first insulating regions SS1 may extend by intersecting the memory region R1a and the string selection region R1b in the X-direction. The first insulating regions SS1 may include a plurality of first insulating regions SS1 parallel to each other between the separation regions MS and spaced apart in the Y-direction, and may selectively separate only the upper gate electrodes 130U1 to 130U3, similarly to the second insulating regions SS2.

The first insulating regions SS1 and the second insulating regions SS2 may be disposed to have the same length from the upper portion in the Z-direction, and lower surfaces thereof may be disposed on a level lower than that of a lower surface of a lowermost upper gate electrode 130U1 among the upper gate electrodes 130U1 to 130U3, and may be disposed on a level higher than that of a lower surface of the interlayer insulating layer 120 below the lowermost upper gate electrode 130U1. Accordingly, the first insulating regions SS1 and the second insulating regions SS2 may completely penetrate through the upper gate electrodes 130U1 to 130U3, so that the upper gate electrodes 130U1 to 130U3 may form a plurality of sub-regions that are physically/electrically completely separated.

The insulating regions SS1 and SS2 may separate the extension region R2 and the string selection region R1b, and the upper gate electrodes 130U1 to 130U3 may be separated into a plurality of sub-regions in the Y-direction in the memory region R1a and the string selection region R1b and may form a single plate shape without being separated in the extension region R2. In this case, the insulating regions SS1 and SS2 may selectively penetrate through only the upper gate electrodes 130U1 to 130U3 and may not extend below the memory gate electrode 130M, so that the memory gate electrodes 130M and the lower gate electrodes 130L may not be separated by the insulating regions SS1 and SS2, and the memory region R1a, the string selection region R1b, and the extension region R2 may all be stacked in a single plate shape, respectively.

The first insulating regions SS1 may be disposed by intersecting a portion of the channel structures CH in the memory region R1a. The first insulating regions SS1 have a predetermined width in the Y-direction, and may extend by intersecting a space between a plurality of channel structures CH arranged in a matrix in a zigzag shape in the X-direction. Accordingly, when the plurality of channel structures CH are arranged to have the same separation distance, the first insulating regions SS1 may extend by intersecting one column of channel structures CH at the same time. The first insulating regions SS1 may be depressed into a portion of the channel structure CH facing an upper portion of the channel structures CH, for example, three upper gate electrodes 130U, as illustrated in FIG. 4B, and thus a portion of the channel structures CH may be removed. In this case, the channel structures CH may be depressed by a length smaller than a radius of the channel structure CH from a channel center axis to an inner wall of a channel hole. Accordingly, the first insulating regions SS1 may be disposed so that the first insulating regions SS1 does not pass through the channel center axis of the channel structure CH and at least 1/2 of the channel structure CH remains on an upper surface thereof, but the present disclosure is not limited thereto. The channel structures CH into which the first insulating regions SS1 are depressed may be effective channel structures that actually function as memory cells, not dummy channel structures. The insulating regions SS1 and SS2 may each include an insulating material. The insulating regions SS1 and SS2 may include the insulating material and may include, for example, silicon oxide, silicon nitride, or silicon oxynitride.

The channel structures CH may be spaced apart from each other to form rows and columns on the conductive layer 101 in the memory region R1a of the cell region R1. In the memory region R1a, the channel structures CH may be arranged in a zigzag shape in the X-Y plane in one direction. The channel structures CH may penetrate through the gate electrodes 130, and may extend in a vertical direction, perpendicular to the upper surface of the conductive layer 101, for example, in the Z-direction, and may have a pillar shape and may have an inclined side surface whose width, in the Y-direction, becomes narrower as the channel structures CH extend in the Z-direction towards the conductive layer 101 according to the aspect ratio.

Each of the channel structures CH may have a form in which k channel portions respectively penetrating through k stack structures GS1 to GSk of the gate electrodes 130 are connected, and in an example embodiment, three channel portions respectively penetrating through three stack structures GS1 to GS3 may be connected to each other. The term "connected" (or "connecting," or like terms, such as "contact" or "contacting"), as may be used herein, is intended to refer to a physical and/or electrical connection between two or more elements, and may include other intervening elements. As used herein, the term "and/or" includes any and all combinations of one or more of the associated listed items. A bend portion may be provided due to a difference or a change in width in a connection portion between the channel portions.

As illustrated in FIG. 3A, each of the channel portions may be configured so that a width in the Y-direction in an upper end thereof is greater a width in a lower end thereof, and a side surface may have a slope surface whose width in the Y-direction decreases as the channel portion extends in the Z-direction towards the conductive layer 101 due to the difference in width between the upper end and the lower end. The bend portion may be disposed in boundary surfaces of the first to third stack structures GS1 to GS3, and upper surfaces of each of the channel portions may be coplanar with upper surfaces of the first to third stack structures GS1 to GS3.

Each of the channel structures CH may include a first portion in the stack structure GS1 to GS3 and a second portion protruding below the stack structure GS1 to GS3 and coming into contact with the conductive layer 101.

The channel layer 140 (see FIGS. 4A and 4B) may be disposed entirely in the first and second portions of the channel structures CH, and may be disposed up to an upper end of the second portion. The channel layer 140 may include a protrusion portion disposed in the second portion of the channel structures CH and protruding and exposed below the stack structures GS1 to GS3 and a non-protrusion portion disposed in the first portion of the channel structure CH. The term "exposed" (or "exposing," or like terms) may be used herein to describe relationships between elements and/or with reference to intermediate processes in fabricating a semiconductor device, but may not require exposure of a particular element in the completed device. Likewise, the term "not exposed" may be used to described relationships between elements and/or with reference to intermediate processes in fabricating a semiconductor device, but may not require a particular element to be unexposed in the completed device. Length at which the second portions of the channel structures CH, e.g., the protrusion portions of the channel layer 140 protrude may not be the same, but the present disclosure is not limited thereto. The channel layer 140 may be formed in an annular shape with a side surface surrounding a buried insulating layer 147 inside, but may also have a pillar shape such as a cylinder or a prism without the buried insulating layer 147 according to an example embodiment. The protrusion portion of the channel layer 140 may extend into the conductive layer 101 and may directly contact the conductive layer 101. The protrusion portion may be formed to have a gentle slope with respect to the non-protrusion so as to maintain the annular shape, as illustrated in FIG. 3A. The channel layer 140 may include a semiconductor material such as polycrystalline silicon or single-crystal silicon, and the semiconductor material may be an undoped material or a material including P-type or N-type impurities.

As illustrated in FIGS. 4A and 4B, channel pads 149 may be disposed in an upper portion of the channel layer 140 in the channel structures CH. The channel pads 149 may be disposed to cover an upper surface of the buried insulating layer 147 and be electrically connected to the channel layer 140. The term "cover" (or "covers," or like terms), as may be used herein, is intended to broadly refer to an element, structure or layer that is on or over another element, structure or layer, either directly or with one or more other intervening elements, structures or layers therebetween. The channel pads 149 may include, for example, doped polycrystalline silicon.

A channel dielectric layer 145 may be disposed between the gate electrodes 130 and the channel layer 140. The channel dielectric layer 145 may include a tunneling layer 141, a charge storage layer 142, and a blocking layer 143 sequentially stacked in the Y-direction from the channel layer 140. The tunneling layer 141 may tunnel charges into the charge storage layer 142, and may include, for example, silicon oxide ($SiO_2$), silicon nitride ($Si_3N_4$), silicon oxynitride (SiON), or combinations thereof, although embodiments are not limited thereto. The charge storage layer 142 may be a charge trap layer or a floating gate conductive layer. The blocking layer 143 may include silicon oxide ($SiO_2$), silicon nitride ($Si_3N_4$), silicon oxynitride (SiON), a high-k dielectric material, or combinations thereof. According to example embodiments, at least a portion of the channel dielectric layer 145 may form a channel dielectric layer extending horizontally along the gate electrodes 130.

The channel dielectric layer 145 may be removed below the stack structures GS1 to GS3 so that the protrusion portion of the channel layer 140 is exposed to the outside in the second portion. Accordingly, a lower end of the channel dielectric layer 145 may be in contact with the conductive layer 101, and a side surface of the channel dielectric layer 145 may be disposed to surround the non-protruding portion of the channel layer 140 in the first portion. The term "surround" (or "surrounds," or like terms), as may be used herein, is intended to broadly refer to an element, structure or layer that extends around, envelops, encircles, or encloses another element, structure or layer on all sides, although breaks or gaps may also be present. Thus, for example, a material layer having voids or gaps therein may still "surround" another layer which it encircles. The channel layer 140, the channel dielectric layer 145, and the buried insulating layer 147 may be connected to each other between the channel portions.

Referring to FIGS. 3B and 3C, the support structures DH may be disposed in the string selection region R1b and the extension region R2, and may have the same or similar structure as the channel structures CH, but may not perform a substantial function in the semiconductor device 100. The support structures DH may have a diameter equal to or larger than a maximum diameter of the channel structures CH, and may have a diameter smaller than maximum diameters of the contact plugs MC1 and MC2. The shape, number, and/or gap of the support structures DH may be different from each other. The channel structures CH and the support structures DH may have a circular or nearly circular shape, but the present disclosure is not limited thereto and the channel structures CH and the support structures DH may have an elliptical shape. The support structures DH may include vertical portions penetrating through the stack structures GS1 to GS3, similarly to the channel structures CH, and extending in the Y-direction, and horizontal portions protruding from the vertical portions toward each gate electrode 130, but the shape of the support structures DH is not limited thereto. The support structures DH may also have a structure including a plurality of bend portions corresponding to the bend portions of the channel portions of the channel structures CH. The support structures DH may be supporters capable of preventing deformation such as bending of the stack structures GS1 to GS5. The support structures DH may include expansion portions expanded in a horizontal direction to have a larger diameter in a portion penetrating through the gate electrodes 130, but the present disclosure is not limited thereto.

The semiconductor device 100 may include contact plugs MC1 and MC2 connected to gate electrodes 130 in the string selection region R1b and the extension region R2, respectively. The contact plugs MC1 and MC2 penetrate an uppermost interlayer insulating layer 121, and may extend downwardly in the Z-direction to be connected to upper surfaces of the assigned gate electrodes 130. As illustrated in FIG. 2, the contact plugs MC1 and MC2 may have a circular or elliptical shape on the X-Y plane and may be spaced apart from each other in the X-direction, the Y-direction, and a D-direction.

Referring to FIG. 4C, each of the contact plugs MC1 and MC2 may include a plug conductive layer 175 and a contact barrier layer 172 surrounding a side surface and a lower surface of the plug conductive layer 175, and a side insulating layer 160 may be further disposed on a side surface of the contact barrier layer 172 of the contact plugs MC1 and MC2. The contact plugs MC1 and MC2 and the side insulating layer 160 surrounding side surfaces of the contact plugs MC1 and MC2 may be referred to as a contact structure.

In each of the contact plugs MC1 and MC2, a lower surface of the contact barrier layer 172 may be in contact with and connected to a contact region of one of the gate electrodes 130, and the side insulating layer 160 may electrically insulate the gate electrodes 130 adjacent to a side surface of the plug conductive layer 175 from the plug conductive layer 175. The plug conductive layer 175 may extend continuously in the Z-direction from lower surfaces of the contact plugs MC1 and MC2 in contact with the contact region of the gate electrode 130 to upper surfaces of the contact plugs MC1 and MC2.

The plug conductive layer 175 of the contact plugs MC1 and MC2 may include a conductive material, for example, at least one of tungsten (W), copper (Cu), aluminum (Al), and alloys thereof. For example, the plug conductive layer 175 may include tungsten (W). The contact barrier layer 172 may include tungsten nitride (WN), tantalum nitride (TaN), titanium nitride (TiN), or combinations thereof.

The side insulating layers 160 may include an insulating material, and may include, for example, silicon oxide, silicon nitride, or silicon oxynitride.

Some of the contact plugs MC1 and MC2 may be disposed to extend to a level lower than that of an upper surface of the assigned gate electrode 130, but may not extend to a level lower than a lower surface of the assigned gate electrode 130. Accordingly, the lower surfaces of the contact plugs MC1 and MC2 may be disposed on a level identical to or lower than the upper surfaces of the gate electrode 130 in contact therewith, and may be disposed on a level higher than the lower surfaces thereof.

The contact plugs MC1 and MC2 may be configured so that a lower surface thereof has a smaller width in the Y-direction than that of an upper surface thereof, and a width thereof decreases as the upper surface extends in the Z-direction towards the lower surface. Accordingly, a side surface between the upper surface and the lower surface may have a slope. Additionally, some of the contact structures may include a bend portion in a side surface thereof, and the number of bend portions may be variously applied.

The contact plugs MC1 and MC2 may include string selection contact plugs MC1 and word line contact plugs MC2.

The string selection contact plugs MC1 may be disposed in the string selection region R1b, and may be respectively connected to the predetermined number of upper gate electrodes 130U1 to 130U3 functioning as string selection lines, among the upper gate electrodes 130U.

Since three string selection lines are illustrated as being included, when an example embodiment is described based thereon, three string selection contact plugs MC1 connected to the upper gate electrodes 130U1 to 130U3, which are each string selection line, may be arranged in each sub-region. That is, the string selection contact plugs MC1 connected to each of the string selection lines may be disposed in the sub-regions of the upper gate electrodes 130U divided by the first and second insulating regions SS1 and SS2. In an example embodiment, each of the upper gate electrodes 130U1 to 130U3 is illustrated as being connected to one string selection contact plug MC1, but, alternatively, a plurality of string selection contact plugs MC1 may be connected to one upper gate electrode 130U1 to 130U3. Accordingly, the number of string selection contact plugs MC1 assigned to each of the sub-regions may be identical, and the number of string selection contact plugs MC1 assigned to each of the sub-regions may satisfy an integer multiple of the number of gate electrodes functioning as string selection lines.

In each of the sub-regions, the first to third upper gate electrodes 130U1 to 130U3 may be individually connected by three string selection contact plugs MC1 to transmit an electrical signal, thereby selecting the channel structure CH of the corresponding sub-regions.

The string selection contact plugs MC1 do not protrude outside the sub-regions of the first to third upper gate electrodes 130U1 to 130U3 and may directly contact the upper surfaces of the assigned upper gate electrodes 130U, respectively. Accordingly, the string selection contact plugs MC1 do not extend outside each sub-region formed by cutting the three first to third upper gate electrodes 130U1 to 130U3, i.e., below the third upper gate electrode 130U1.

In the extension region R2, when word line contact plugs MC2 respectively connected to the memory gate electrodes 130M and the lower gate electrodes 130L are assigned one by one, the word line contact plugs MC2 may extend by different lengths so as to be connected to the gate electrodes 130M and 130L having different levels.

In an example embodiment of FIGS. 3A to 3C, the first to third stack structures GS1 to GS3 are illustrated as including 10 layers of gate electrodes 130, respectively, and since the three upper gate electrodes 130U function as string selection lines, 27 gate electrodes 130M and 130L may remain. The word line contact plugs MC2 in which lengths thereof are adjusted differently so as to contact the upper surfaces of the 27 gate electrodes 130M and 130L may be disposed in the extension region R2. The number of word line contact plugs MC2 disposed in each of the blocks BLK1 and BLK2 may be the same.

The word line contact plugs MC2 may be variously arranged, and when viewed from the top as illustrated in FIG. 2, the word line contact plugs MC2 may be arranged to form rows and columns, and may be arranged in a zigzag shape with the word line contact plugs MC2 of an adjacent row.

In the basic portion Aa of the extension region R2, the word line contact plugs MC2 may be disposed to form a regular hexagonal arrangement, and a separation distance d1 (e.g., a pitch, a center distance of each contact plug) between six adjacent word line contact plugs MC2 may be constant. Specifically, one word line contact plug MC2 may be arranged in the D-direction with the word line contact plugs MC2 disposed in an adjacent column. The D-direction is a direction inclined with respect to the X-direction and the Y-direction, and in a case in which the word line contact plug MC2 has a regular hexagon, the word line contact plug MC2 may have an inclination of 60 degrees with respect to the X-direction. Accordingly, for one word line contact plug MC2, a separation distance d1 from an adjacent contact plug MC2 in the X-direction may be a same as the separation distance d2 from an adjacent contact plugs MC2 in the D-direction. In this case, when the word line contact plugs MC2 are arranged in a regular hexagon, a separation distance dy in the Y-direction between centers of the adjacent contact plugs MC2 may satisfy √3/2xd1 with respect to the separation distance d1 from the adjacent contact plug MC2 in the X-direction, and when the separation distance d2 in the D-direction is greater than a separation distance dx in the X-direction, the separation distance dy in the Y-direction may gradually increase. Even if the separation distance dy in the Y-direction has a value greater than √3/2xd1, the separation distance dy in the Y-direction may not exceed √3/2xd1x1.5. When the separation distance dy in the Y-direction is √3/2xd1x1.5 or more, one more column of contact plugs MC2 may be arranged. Meanwhile, the word line contact plugs MC2 in the extension region R2 may form a hexagonal arrangement so that the separation distances d1 in the X-direction may be identical to each other, the separation distances d2 in the D-direction may be identical to each other, and the separation distance d1 in the X-direction may be arranged to be shorter than the separation distance d2 in the D-direction. The separation distance d1 in the X-direction and the separation distance d2 in the D-direction are identical to or greater than a minimum separation distance. The minimum separation distance may be defined as a minimum distance between the adjacent contact plugs MC2 that does not affect the process.

When the number of word line contact plugs MC2 arranged in one row in the basic portion Aa of the extension region R2 is n, in a case of forming m rows, n×m word line contact plugs MC2 may be disposed, and n/2 word line contact plugs MC2 may be further disposed in the expansion portion Ab of the extension region R2 of each of the blocks BLK1 and BLK2. Accordingly, n×m+n/2 word line contact plugs MC2 may be disposed in the extension region R2 of one block BLK.

That is, n×m+n/2 word line contact plugs MC2 whose lengths are adjusted differently so as to contact the upper surfaces of the gate electrodes 130M and 130L, respectively, may be disposed in the extension region R2, and in this case, the n×m+n/2 word line contact plugs may be equal to or greater than the number of memory gate electrodes 130M and lower gate electrodes 130L, and more than 27 word line contact plugs MC2 may be defined as dummy word line contact plugs. In FIG. 2, one dummy word line contact plug MC2 may be understood as being disposed, which does not perform a function of selecting an actual word line, but may function like a support structure DH.

A length of the word line contact plugs MC2 disposed in the extension region R2 may be variously adjusted. For example, in one row, the assigned gate electrodes 130 may be lowered by one layer toward the X-direction, so that the assigned gate electrodes 130 may be elongated by one layer of gate electrode 130 and interlayer insulating layer 120 in the Z-direction. Accordingly, in the word line contact plugs MC2 disposed in the X-direction, when the uppermost gate electrode 130 is referred to as a first gate electrode 130U3, a length thereof in the Z-direction may increase so that the word line contact plugs MC2 contact each of a fourth gate electrode 130 to an eleventh gate electrode 130. In a second row, the word line contact plugs MC2 may extend again to contact a twelfth gate electrode 130.

In this manner, the word line contact plugs MC2 may have a longer length as the word line contact plugs MC2 move away from the cell region R1 in the X-direction. Additionally, the word line contact plugs MC2 may have a longer length as the word line contact plugs MC2 move downwardly in the Y-direction, but the present disclosure is not limited thereto.

In the arrangement of the word line contact plugs MC2 in the extension regions R2 in the two adjacent blocks BLK1 and BLK2 included in one block group BLKb, based on (i.e., with respect to) the second separation region MSb, the arrangements of the basic portions Aa may be mirror-symmetrical to each other, and the arrangements of the expansion portion Ab may be similar to each other. The expansion portions Ab of the two adjacent blocks BLK1 and BLK2 included in one block group BLKb may be successively arranged in the X-direction, and may be arranged in a form in which the expansion portions Ab face each other by the second bend portion S5 of the second separation region MSb.

The word line contact plugs MC2 of the two expansion portions Ab successively arranged may be arranged in a row extending in the X-direction, and each row of the word line contact plugs MC2 of the expansion portion Ab of the first block BLK1 may be arranged to be offset in the Y-direction from rows of the word line contact plugs MC2 of the expansion portion Ab of the second block BLK2.

In the string selection region R1b and the extension region R2, the support structures DH may be disposed to have a regular pattern around the contact structures MC1 and MC2. For example, as illustrated in FIG. 2, three support structures DH may be assigned to the word line contact structure MC2 to support the word line contact plugs MC2, and the support structures DH may be further disposed in a surplus space. Additionally, in the string selection region R1b, the support structures DH may be disposed alternately with the string selection contact plugs MC1, but the present disclosure is not limited thereto.

A second distance I2 in the Y-direction between the first and second separation regions MSa and MSb and the closest support structure DH in the extension region R2 of each of the blocks BLK1 and BLK2 may be equal to or greater than the minimum separation distance. The second distance I2 in the Y-direction between the first separation region MSa and the support structure DH closest thereto may be greater than a first distance I1 in the Y-direction between the first separation region MSa and the channel structure CH closest thereto in the cell region R1. The first distance I1 may also be equal to or greater than the minimum separation distance.

Additionally, a contact separation distance I3 in the Y-direction between the first and second separation regions MSa and MSb and the word line contact plugs MC2 closest thereto in the extension region R2 of each the blocks BLK1 and BLK2 may be greater than the minimum separation distance and greater than the second distance I2. However, the contact separation distance I3 may be smaller than the separation distances d1 and d2 between the word line contact plugs MC2.

When a ratio ((dm - I3)/dy) of a difference between a distance dm (e.g., a vertical distance in the Y-direction) from a center of the contact plug MC2 of a last row of the basic portion Aa to a center of the second separation region MSb of the cell region R1 and the contact separation distance I3 and the separation distance dy in the Y-direction between centers of the contact plugs MC2 is referred to as a surplus ratio R, the number of blocks BLK1 and BLK2 in one block group BLKb and the number of contact plugs MC2 disposed in the expansion portion Ab in the block group BLKb may be determined according to the surplus ratio R.

When the surplus ratio R is greater than 0 and less than 1, one more row of word line contact plugs MC2 may not be disposed in the basic portion Aa, but since there is a distance greater than the contact separation distance I3, a surplus space may be present. The surplus space may be mixed with a surplus space of another block BLK in one block group BLKn to form expansion portions Ab so that at least one more row of word line contact plugs MC2 may be disposed in one block group BLKn. That is, by bending the second separation region MSb, at least one word line contact plug MC2 may be disposed in each of the expansion portions Ab.

In the expansion portions Ab, at least one row of word line contact plugs MC2 may be disposed to satisfy the separation distances d1, but the number of contact plugs MC2 in one row in the expansion portions Ab may be smaller than the number of contact plugs MC2 in one row of the basic portions Aa. The separation distance between the second separation region MSb and the contact plugs MC2 adjacent to each other in the Y-direction may satisfy the contact separation distance I3. Accordingly, since the contact plugs MC2 are disposed without any excess space in the extension region R2, more contact plugs MC2 may be disposed in one block BLK.

The semiconductor device 100 of FIG. 2 illustrates a case in which the surplus ratio R is 0.5. In the case in which the surplus ratio R is 0.5, when n word line contact plugs MC2 are disposed in one row of the basic portions Aa, n/2 word line contact plugs MC2 may be disposed in each of the expansion portions Ab. That is, the number of blocks BLK1 and BLK2 in which the word line contact plugs MC2 of one row may be distributed may be determined, and the number of word line contact plugs MC2 assigned to each of the blocks BLK1 and BLK2 may be determined. Accordingly, an area of the expansion portions Ab of the extension region R2 may be determined. In an example embodiment, the integer that makes the surplus ratio R a minimum integer may be defined as the number of blocks BLK1 and BLK2 is synthesized in one block group BLKb.

That is, the number of blocks BLK1 and BLK2 may be set so as to satisfy the following equation 1.

$$\text{Equation 1:}$$

$$R \times a = k, \ k = \text{minimum natural number}$$

In Equation 1 above, a may represent the number of blocks BLK1 and BLK2 synthesized in one block group BLKb, and a may be smaller than a critical block number. Additionally, k in Equation 1 is a minimum natural number, and represents the number of rows of redistributed word line contact plugs MC2.

For example, the critical block number synthesized in one block group BLKb may satisfy 5. When eight blocks are synthesized and one row of word line contact plugs MC2 are distributed and disposed, each of the eight expansion portions Ab may include n/8 word line contact plugs MC2, and when three rows of word line contact plugs MC2 are disposed in the basic portions Aa, a length of an entire extension region R2 in the X-direction may be reduced by less than 4%. Accordingly, when eight or more blocks are synthesized, an effect of area reduction due to synthesis may be smaller than a critical value. In the case in which three rows of word line contact plugs MC2 are disposed in the basic portions Aa, when six blocks are synthesized, the length of the entire extension region R2 in the X-direction may be reduced by less than 6%, so that the effect of area reduction may be less than the critical value. However, values of the synthesized blocks may be variously changed. In other words, miniaturization of a desired device may be achieved by synthesizing six or more blocks.

For example, when there are 5 blocks to be synthesized, a case in which the surplus ratio R is 0.2, 0.4, 0.6 and 0.8 may be included, and when the surplus ratio R is 0.4 or more, if three rows of word line contact plugs MC2 are disposed in the basic portions Aa, the reduction in the length of the entire extension region R2 in the X-direction may be equal to or greater than 10%. Accordingly, a maximum value of the number of blocks in which the efficiency of the reduction in the length of the entire extension region R2 in the X-direction is equal or to greater than 10% may be defined as a critical block number. When the surplus ratio R is less than 0.2, the block group BLKb may not be formed, and a further increase in the separation distance dy in the Y-direction between each of the word line contact plugs MC2 for the surplus space may be reflected. Accordingly, the concept of the present disclosure, which distributes and disposes k rows of word line contact plugs MC2 to a plurality of blocks by forming a block group BLKb, may be applied when the number of composite blocks is less than the number of critical blocks and a value of R is 0.2 or more, but the present disclosure is not limited thereto.

Accordingly, the number of block groups BLKb derived by Equation 1 may be exemplarily illustrated in the following Table 1.

Table 1:

| Embodiment | Surplus Ratio (R) | Equation 1 | Number of Blocks of Block Group BLKb | Number of Contact Plugs in Expansion Portion of Each Block |
|---|---|---|---|---|
| First Embodiment | 0.5 | 0.5×2=1 | 2 | n/2 |
| Second Embodiment | 0.666 | 0.666×3=-2 | 3 | 2n/3 |
| Third Embodiment | 0.333 | 0.333×3=-1 | 3 | n/3 |
| Fourth Embodiment | 0.25 | 0.25×4=1 | 4 | n/4 |
| Fifth Embodiment | 0.4 | 0.4×5=2 | 5 | 2n/5 |
| Sixth Embodiment | 0.6 | 0.6×5=3 | 5 | 3n/5 |

In Table 1 above, n may be defined as the number of word line contact plugs MC2 disposed in one row of the basic portion Aa.

In the second embodiment, two rows of word line contact plugs MC2 may be distributed and disposed in the expansion portion Ab of the extension region R2 of three blocks, and in the third embodiment, one row of word line contact plugs MC2 may be distributed and disposed in the expansion portions Ab of three blocks.

In the fourth embodiment, one row of word line contact plugs MC2 may be distributed and disposed in the expansion portions Ab of four blocks, and in the fifth embodiment, two rows of word line contact plugs MC2 may be distributed and disposed in the expansion portions Ab of five blocks, and in the sixth embodiment, three rows of word line contact plugs MC2 may be distributed and disposed in the expansion portions Ab of five blocks.

In this case, when the surplus ratio R is greater than 0.2 but the number of synthetic blocks exceeds the critical block number (when the integer multiple that makes the R value an integer is significantly large), the surplus ratio R may be converted to an approximate proximity surplus ratio R' that may form an integer multiple less than the critical block number, and then the number of synthetic blocks equal to or less than the critical block number may be satisfied, so that the remaining surplus space due to a difference between the proximity surplus ratio R' and the surplus ratio R may be reflected in the separation distance dy in the Y-direction between the contact plugs MC2.

For example, when the surplus ratio R is 0.42, this may be converted to the proximity surplus ratio R' of 0.4, and 5 blocks may be set to form one block group BLKb, and the surplus space of 0.02 may be reflected in the separation distance dy in the Y-direction between the contact plugs MC2, so that the space between the word line contact plugs MC2 may further increase.

In this way, lengths L1, L2 and L3 in the Y-direction may be formed differently between the cell region R1 and the extension region R2 in one block BLK1 and BLK2, and the word line contact plugs MC2 may be disposed maximally without any surplus space in the Y-direction while maintaining the separation distance between the word line contact plugs MC2 in the extension region R2 to be equal to or greater than the minimum separation distance, thereby minimizing a length of the extension region R2 in the X-direction.

Accordingly, an overall size of the semiconductor device 100 may be reduced, and the word line contact plugs MC2 may be disposed at a higher density by synthesizing the surplus spaces between the adjacent blocks BLK1 and BLK2.

The cell region insulating layer 150 may cover the stack structure GS. The cell region insulating layer 150 may include a plurality of insulating layers according to example embodiments. The cell region insulating layer 150 may be formed of an insulating material, and may include, for example, at least one of silicon oxide, silicon nitride, and silicon oxynitride.

The studs 185 and the cell interconnection lines 180 may be included in a cell interconnection structure electrically connected to the memory cells. The studs 185 may be electrically connected to the channel structures CH and the contact structures MCa, MCb and MCc by penetrating through a portion of the cell region insulating layer 150, and may be electrically connected to the channel layers 140 and the gate electrodes 130. The studs 185 may have a plug shape, and the cell interconnection lines 180 may have a line shape, but the present disclosure is not limited thereto. The studs 185 and the cell interconnection lines 180 may include a metal, such as, for example, tungsten (W), copper (Cu) and/or aluminum (Al).

An upper insulating layer 190 may be further disposed on the cell region insulating layer 150, and the cell interconnection lines 180 may be disposed in the upper insulating layer 190. The upper insulating layer 190 may be formed of an insulating material, and may include, for example, at least one of SiO, SiN, SiCN, SiOC, SiON, or SiOCN.

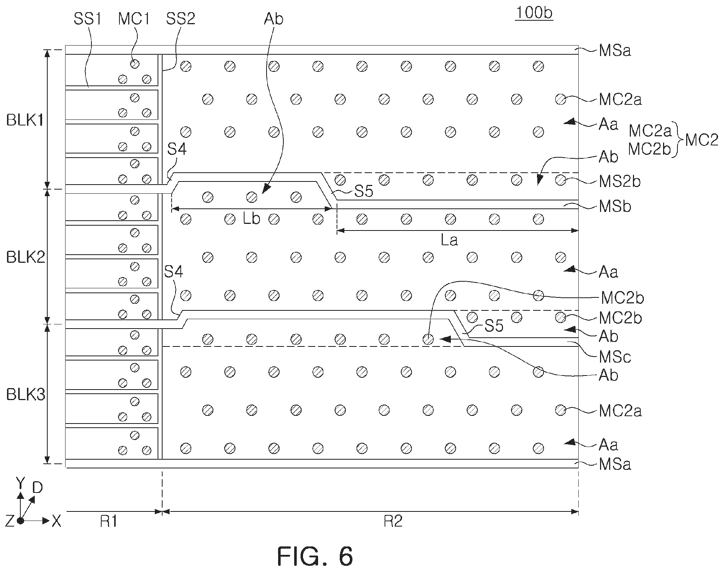

Hereinafter, referring to FIGS. 5 and 6, the arrangement of the separation regions MS and the word line contact plugs MC2 according to other example embodiments of the present disclosure will be described. FIGS. 5 and 6 are schematic top plan views of semiconductor devices according to example embodiments.

A semiconductor device 100a of FIG. 5 is identical to the semiconductor device 100 of FIGS. 1 to 4C, except that one block group BLKb includes three blocks BLK1 to BLK3, and one row of word line contact plugs MC2 are distributed to the three blocks BLK1 to BLK3 and disposed in the expansion portion Ab of the extension region R2.

The semiconductor device 100a of FIG. 5 illustrates the arrangement of the block group BLKb and the word line contact plugs MC2 for the third embodiment of Table 1.

A surplus ratio R of the semiconductor device 100a of FIG. 5 may satisfy 0.333.

Accordingly, by Equation 1, in the semiconductor device 100a, three blocks BLK1 to BLK3 may be disposed in one block group BLKb, and 1/3 of the word line contact plugs MC2 of one row may be additionally disposed in the expansion portion Ab of each block BLK.

The word line contact plugs MC2 disposed in the existing portion Aa, among the word line contact plugs MC2, may be defined as a first contact plug MC2a, and the word line contact plugs MC2 disposed in the expansion portion Ab may be defined as a second contact plugs MC2b. The number of first contact plugs MC2a may be the same for each of blocks BLK1 to BLK3, and the number of second contact plugs MC2b may also be the same for each of blocks BLK1 to BLK3.

To this end, blocks BLK1, BLK2 and BLK3 in the block group BLKb may be defined as a first block BLK1, a second block BLK2, and a third block BLK3 in the Y-direction, and the first separation regions MSa disposed in an upper portion of the first block BLK1 and disposed in a lower portion of the third block BLK3 may extend in parallel in the X-direction.

The second separation region MSb and the third separation region MSc having bend portions S4 and S5 may be disposed between the first block BLK1 and the second block BLK2, and between the second block BLK2 and the third block BLK3.

In the first block BLK1, an expansion portion Ab of the extension portion R2 may be disposed adjacently to the string selection region R1b (see FIG. 2), and word line contact plugs MC2 of 1/3 rows may be further disposed in the expansion portion Ab. The second separation region MSb may include a first bend portion S4 bent downwardly (i.e., having a negative slope) from the expansion portion Ab, and may include a second bend portion S5 extending in the X-direction and bent upwardly (i.e., having a positive slope), and may extend in the X-direction again.

That is, the second separation region MSb may have a different position from the second bend portion S5 bent upwardly with the second separation region MSb of FIG. 2, but may have the same shape as that of the second bend portion S5. That is, as a position of the second bend portion S5 of the second separation region MSb approaches the cell region R1, a length La in the X-direction of the expansion portion Ab may be smaller than the length in the X-direction of the expansion portion Ab of FIG. 2. Additionally, the length La of the expansion portion Ab may be shorter than a length Lb of the basic portion Aa, but the present disclosure is not limited thereto.

The third separation region MSc intersecting a space between the second block BLK2 and the third block BLK3 may include bend portions S4 and S5 for arranging the same number of word line contact plugs MC2 as the first block BLK1 in the second block BLK2. The first bend portion S4 of the third separation region MSc may be disposed on the same level as the second separation region MSb in the Y-direction, and may extend in the X-direction and may be bent again by the second bend portion S5. In this case, the positions of the second bend portions S5 of the second separation region MSb and the third separation region MSc may be different from each other, and the second bend portion S5 of the third separation region MSc may be disposed further from the cell region R1 than the first bend portion S4 of the second separation region MSb. Accordingly, the expansion portion Ab of each block BLK may substantially include a length of 1/3 of a total length in the Y-direction, and a substantial expansion region Ab of the second block BLK2 may correspond to a difference between a depression portion due to the expansion portion Ab of the first block BLK1 in an upper portion and the expansion portion Ab of the second block BLK2.

The third block BLK3 may be disposed between the third separation region MSc and the first separation region MSa, the expansion portion Ab may be disposed furthest from the cell region R1 by the second bend portion S5 of the third separation region MSc, and the second contact plugs MC2b may be disposed in the expansion portion Ab by 1/3 of one row of the first contact plugs MC2a.

In this manner, regarding a position of the expansion portion Ab in which the word line contact plugs MC2 of the 1/3 row are further disposed, the first block BLK may be disposed in a region close to the string selection region R1b, the second block BLK2 may be disposed in a direction further away from the string selection region R1b in the X-direction, and the third block BLK3 may be disposed in the furthest position.

A semiconductor device 100b of FIG. 6 is identical to the semiconductor device 100a of FIG. 5, except that one block group BLKb includes three blocks BLK1 to BLK3, and two rows of word line contact plugs MC2 are distributed to three blocks BLK1 to BLK3 and disposed in the expansion portions Ab.

The semiconductor device 100b of FIG. 6 illustrates the arrangements of the block group BLKb and the word line contact plugs MC2 for the second embodiment of Table 1.

Specifically, the semiconductor device 100b of FIG. 6 may satisfy the surplus ratio R of 0.666.

The word line contact plugs MC2 disposed in the basic portion Aa among the word line contact plugs MC2, may be defined as the first contact plug MC2a, and the word line contact plugs MC2 disposed in the expansion portion Ab may be defined as the second contact plugs MC2b. The number of first contact plugs MC2a may be the same for each of the blocks BLK1 to BLK3, and the number of second contact plugs MC2b may also be the same for each of the blocks BLK1 to BLK3.

By Equation 1, in a semiconductor device 100b, three blocks BLK1 to BLK3 may be disposed in one block group BLKb, and 1/3 of second contact plugs MC2b of the first contact plugs MC2a of two rows of each block BLK1 to BLK3 may be disposed in each of the expansion portions Ab.

To this end, blocks BLK1, BLK2 and BLK3 in the block group BLKb may be defined as a first block BLK1, a second block BLK2 and a third block BLK3 in the Y-direction, and the first separation regions MSa disposed in an upper portion of the first block BLK1 and disposed in a lower portion of the third block BLK3 may extend in the X-direction.

A second separation region MSb and a third separation region MSc having the bend portions S4 and S5 may be disposed between the first block BLK1 and the second block BLK2, and between the second block BLK2 and the third block BLK3, respectively.

In the first block BLK1, the expansion portion Ab of the extension region R2 may be disposed adjacently to a string selection region R1b (see FIG. 2), and word line contact plugs MC2 of 2/3 rows may be further disposed in the expansion portion Ab. The second separation region MSb may include a first bend portion S4 bent upwardly along the basic portion Aa, and may include a second bend portion S5 extending again in the X-direction and then bent downwardly, and may extend in the X-direction again to define the expansion portion Ab.

The second separation region MSb is the reverse of the second separation region MSb of FIG. 2, and the expansion portion Ab may be disposed to be longer. That is, the length La in the X-direction of the expansion portion Ab may be longer than the length La of the expansion portion Ab of FIG. 5, and may be about twice as long. Additionally, the length La of the expansion portion Ab may be longer than the length Lb in the X-direction of the basic portion Aa, but the present disclosure is not limited thereto.

The third separation region MSc intersecting a space between the second block BLK2 and the third block BLK3 may include bend portions S4 and S5 for arranging the same number of word line contact plugs MC2 as the first block BLK1 in the second block BLK2. The first bend portion S4 of the third separation region MSc may be disposed on the same level as the second separation region MSb in the X-direction, and may extend in the X-direction and may be bent again by the second bend portion S5. In this case, the positions of the second bend portions S5 of the second separation region MSb and the third separation region MSc may be different from each other in the X-direction, and the second bend portion S5 of the third separation region MSc may be disposed further from the cell region R1 in the X-direction than the second bend portion S5 of the second separation region MSb. Accordingly, the expansion portion Ab of each of the blocks BLK1 to BLK3 may substantially include a length La of 2/3 of the total length in the X-direction, and the substantial expansion portion Ab of the second block BLK2 may correspond to the sum of a protrusion portion by the basic portion Aa of the first block BLK1 in the upper portion and the expansion portion Ab of the second block BLK2.

The third block BLK3 may be disposed between the third separation region MSc and the first separation region MSa in the Y-direction, and the expansion portion Ab may be disposed closest to the cell region R1 by the first bend portion S4 of the third separation region MSc, and the second contact plugs MC2b of the 2/3 row may be further disposed in the expansion portion Ab.

In this manner, regarding a position of the expansion portion Ab in which the second contact plugs MC2b are further disposed, the first block BLK1 may be disposed in a region far from the string selection region R1b, and the second block BLK2 may be separated into two ends, and the third block BLK3 may be disposed in a region closest to the string selection region R1b.

In this way, even though the same number of blocks BLK1 to BLK3 are included in one block group BLKb in FIG. 5 and FIG. 6, a relative length La of the expansion portion Ab, specifically, the number of word line contact plugs MC2 disposed in the expansion portion Ab, may be made different, thus minimizing the surplus space. That is, since the surplus ratio R of the semiconductor device 100b of FIG. 6 is larger, in order to minimize the larger surplus space, word line contact plugs MC2 of more rows may be redistributed and disposed.

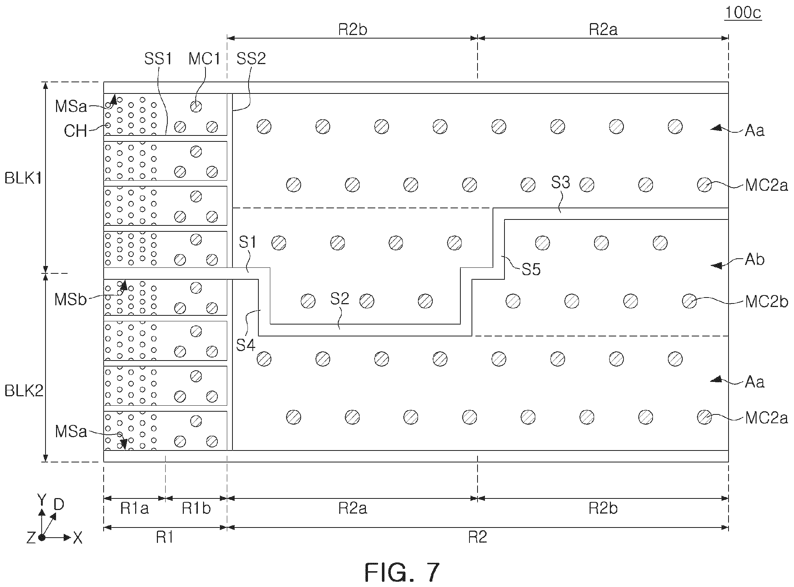

FIGS. 7 to 9 are top plan views showing various example embodiments of the present disclosure.

Referring to FIG. 7, a semiconductor device 100c of FIG. 7 is identical to the semiconductor device 100 of FIGS. 1 to 4C, except that the word line contact plugs MC2 are disposed in two or more rows in the expansion portion Ab of each of the blocks BLK1 and BLK2.

The semiconductor device 100c of FIG. 7 may have lengths of a first bend portion S4 and a second bend portion S5 that may be longer than those of the semiconductor device 100 of FIG. 2 so that the word line contact plugs MC2 may be disposed in two rows in the expansion portion Ab. Additionally, the lengths of the first bend portion S4 and the second bend portion S5 may be different from each other, and the length of the second bend portion S5 may be longer than the length of the first bend portion S4. In FIG. 7, the second bend portion S5 is illustrated as having multiple bend regions and being connected to a third horizontal region S3 to minimize the surplus space, but the present disclosure is not limited thereto. Additionally, the first bend portion S4 and the second bend portion S5 are illustrated as being bent vertically with respect to respective horizontal portions S1 to S3, but the present disclosure is not limited thereto, and the first bend portion S4 and the second bend portion S5 may have an inclination to have an angle smaller than 90 degrees as in FIGS. 2 to 6. In this manner, the surplus space may be minimized by securing the expansion portion Ab larger.

When two rows of word line contact plugs MC2b are disposed in the expansion portion Ab of the first block BLK1, the same number of word line contact plugs MC2b may be disposed in two rows in the expansion portion Ab of the second block BLK2, and may be arranged symmetrically to each other.

In FIG. 7, word line contact plugs MC2b may be disposed in two rows in the expansion portion Ab, but may be disposed in two or more rows in the expansion portion Ab, and even in this case, the number of word line contact plugs MC2b in each expansion portion Ab in each of blocks BLK1 and BLK2 is the same, and the arrangements thereof may be symmetrical to each other.

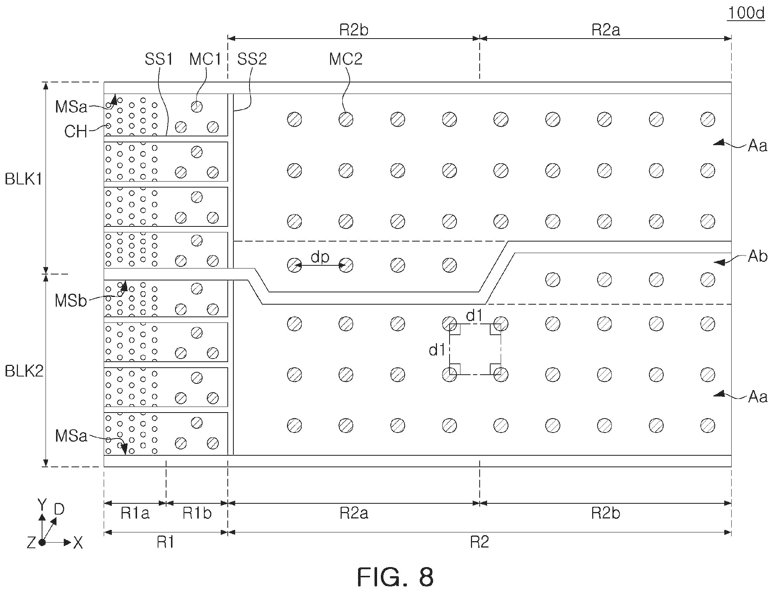

A semiconductor device 100d of FIG. 8 is identical to the semiconductor device 100 of FIGS. 1 to 4C, except that the word line contact plugs MC2 are disposed in a grid type configuration in the extension region R2.

In the semiconductor device 100d of FIG. 8, the word line contact plugs MC2 may be disposed in the grid type configuration, and as adjacent word line contact plugs MC2 may form a square shape, the distances d1 between the adjacent word line contact plugs MC2 in the X-direction may be identical to each other, and the distances d1 between the adjacent word line contact plugs MC2 in the Y-direction may be identical to each other, but the distances between the adjacent word line contact plugs MC2 in the D-direction may be different from the distances in the X-direction or Y-direction.

In this case, the surplus ratio R may be calculated based on the distance d1 in the X-direction.

Accordingly, the word line contact plugs MC2 disposed in the expansion portion Ab may also be disposed in the grid type configuration, but a separation distance dp may satisfy a minimum separation distance or more, but may be smaller than the distance d1 in the X-direction.

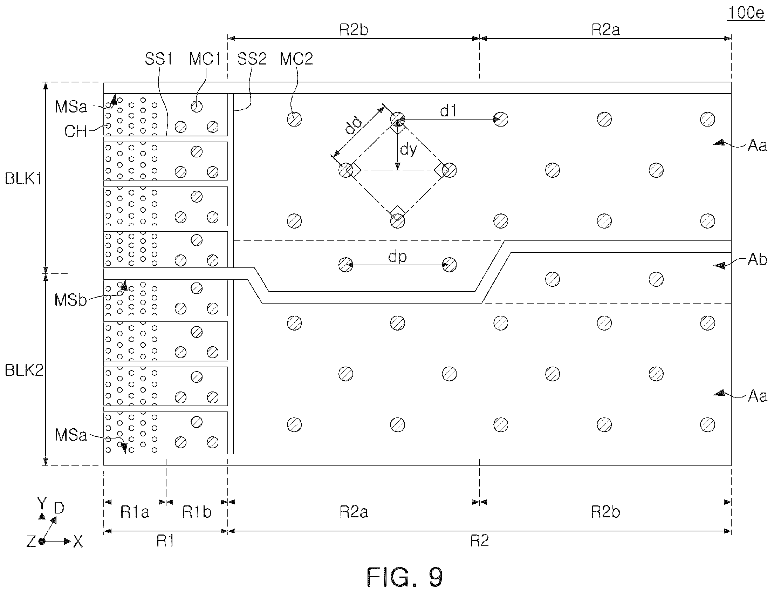

A semiconductor device 100e of FIG. 9 is identical to the semiconductor device 100 of FIGS. 1 to 4C, except that the word line contact plugs MC2 are disposed in a diamond type configuration in the extension region R2.

In the semiconductor device 100e of FIG. 9, all the word line contact plugs MC2 may be arranged in a diamond (rhombus) type configuration and zigzag, and distances of the word line contact plugs MC2 in the D-direction may be identical to each other and the word line contact plugs MC2 may be disposed perpendicularly to each other in the D-direction. A distance dd of the word line contact plugs MC2 in the D-direction may be smaller than the distance d1 between adjacent word line contact plugs MC2 in the X-direction and larger than the distance dy of the word line contact plugs MC2 in the Y-direction.

In this case, the surplus ratio R may be calculated based on the distance dy in the Y-direction.

Accordingly, the word line contact plugs MC2 disposed in the expansion portion Ab may also be arranged in a diamond type configuration, but the separation distance dp may satisfy a minimum separation distance or more, but may be smaller than the distance d1 in the X-direction.

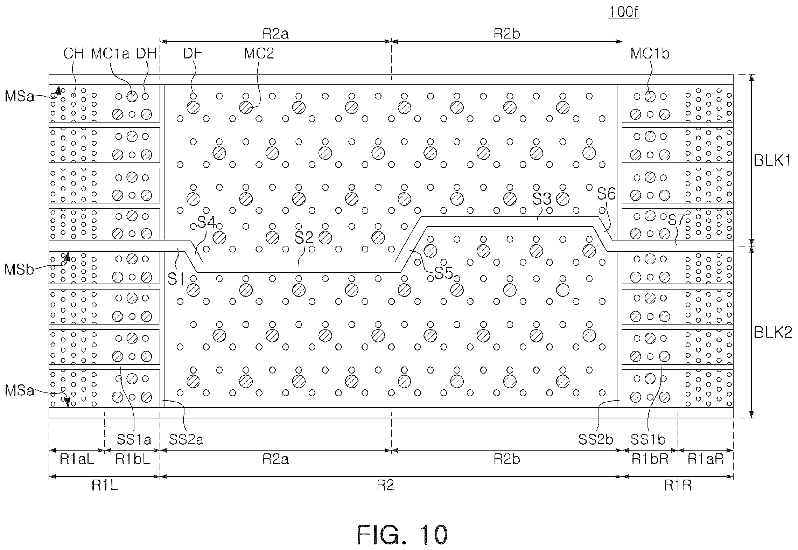

A semiconductor device 100f of FIG. 10 is identical to the semiconductor device 100 of FIG. 1 to FIG. 4C, except that cell regions R1L and R1R on which channel structures CH are disposed on both sides of the extension region R2 are arranged as a left cell region R1L and a right cell region R1R.

The left cell region R1L and the right cell region R1R are memory cell regions on which the memory cell strings are disposed, and may include memory regions R1aL and R1aR on which the channel structures CH are disposed. The extension region R2 may be a region on which a plurality of word line contact plugs MC2 connected to the gate electrodes 130 (see FIG. 3A) on different levels are disposed.

The left cell region R1L and the right cell region R1R may include string selection regions R1bL and R1bR between the left cell region R1L and the right cell region R1R and the extension region R2, respectively. The string selection regions R1bL and R1bR may be defined as regions in which string selection contact plugs MC1a and MC1b for selecting gate electrodes 130 (see FIG. 3A), which are string selection lines, are disposed.

Support structures DH and word line contact plugs MC2 may be disposed in the extension region R2, and support structures DH and string selection contact plugs MC1a and MC1b may be disposed in the string selection region R1bL and R1bR.

Referring to FIGS. 3A - 3C and 10, the gate electrodes 130 may be vertically spaced apart from each other and stacked on the upper surface of the conductive layer 101, thus forming a stack structure GS (GS1, GS2, GS3) along with the interlayer insulating layers 120. The gate electrodes 130 may extend from the extension region R2 to the memory regions R1aL and R1aR on both sides, but upper gate electrodes 130U may be physically and electrically separated between the string selection region R1bL and R1bR and the extension region R2.

The gate electrodes 130 may be vertically spaced apart from each other and stacked, and may maintain a continuous plate shape without forming a step structure having a stepwise shape in the extension region R2.

One end of first insulating regions SS1a and SS1b may extend into the extension region R2 by intersecting second insulating regions SS2a and SS2b, but the present disclosure is not limited thereto, and the first insulating regions SS1a and SS1b may be connected to the second insulating regions SS2a and SS2b.

In the case in which the first and second blocks BLK1 and BLK2 are disposed in each block group BLKb, a second separation region MSb disposed between the first and second blocks BLK1 and BLK2 may further include a third bend portion S6 bent again so that the cell regions R1L and R1R on both sides have the same level, and a fourth horizontal region S7 intersecting the right cell region R1R in the X-direction. Accordingly, the second separation region MSb may have more bend portions S4, S5 and S6 than the second separation region MSb of FIG. 2. In this manner, the word line contact plugs MC2 configured to commonly transmit word line signals to the two cell regions R1L and R1R may be shared, thus achieving miniaturization.

A semiconductor device 100g of FIG. 11 may include the semiconductor device 100 of FIGS. 1 to 4C as a first semiconductor structure CELL, and a second semiconductor structure PERI may be disposed as a peripheral circuit structure on the first semiconductor structure CELL. The first semiconductor structure CELL may be stacked in the Z-direction, which is a vertical direction with respect to the second semiconductor structure PERI. Specifically, the first semiconductor structure CELL may be disposed below the second semiconductor structure PERI in the Z-direction. In example embodiments, on the contrary, the second semiconductor structure PERI may be disposed below the first semiconductor structure CELL.

The first semiconductor structure CELL may further include a bonding structure. Specifically, first bonding vias 195, first bonding metal layers 198, and a first bonding insulating layer may be included in the first bonding structure of the first semiconductor structure CELL. The first bonding vias 195 may be disposed on the cell interconnection lines 180, and the first bonding metal layers 198 may be connected to the first bonding vias 195. Upper surfaces of the first bonding metal layers 198 may be exposed to an upper surface of the first semiconductor structure CELL. The first bonding metal layers 198 may be bonded and connected to second bonding metal layers 298 of the second semiconductor structure PERI. The first bonding vias 195 and the first bonding metal layers 198 may include a conductive material, and may include, for example, copper (Cu). The first bonding insulating layer may form a dielectric-dielectric bond with the second bonding insulating layer of the second semiconductor structure PERI.

Meanwhile, the second semiconductor structure PERI may include a substrate 201, source/drain regions 205 and device isolating layers 210 in the substrate 201, circuit devices 220 disposed on the substrate 201, a peripheral region insulating layer 290, circuit contact plugs 270, circuit interconnection lines 280, second bonding vias 295, and second bonding metal layers 298.

The substrate 201 may have a lower surface extending in the X-direction and the Y-direction. An active region may be defined by the device isolating layers 210 in the substrate 201. The source/drain regions 205 including impurities may be disposed in a portion of the active region. The substrate 201 may include a semiconductor material, such as a group IV semiconductor, a group III-V compound semiconductor, or a group II-VI compound semiconductor. The substrate 201 may be provided as a bulk wafer or an epitaxial layer.

The circuit elements 220 may include a planar (i.e., lateral) transistor. Each of the circuit elements 220 may include a circuit gate dielectric layer 222, a spacer layer 224, and a circuit gate electrode 225. The source/drain regions 205 may be disposed as source/drain regions in the substrate 201 on both sides of the circuit gate electrode 225.

The peripheral region insulating layer 290 may be on a lower surface of the substrate 201 to cover the circuit elements 220. The peripheral region insulating layer 290 may include a plurality of insulating layers formed in different process operations. The peripheral region insulating layer 290 may be formed of an insulating material. A portion of the peripheral region insulating layer 290 may function as a second bonding insulating layer.

The circuit contact plugs 270 and the circuit interconnection lines 280 may be included in a circuit interconnection structure electrically connected to the circuit elements 220 and the source/drain regions 205. The circuit contact plugs 270 may have a cylindrical shape, and the circuit interconnection lines 280 may have a line shape. An electrical signal may be applied to the circuit elements 220 by the circuit contact plugs 270 and the circuit interconnection lines 280. In an unillustrated region, circuit contact plugs 270 may also be connected to the circuit gate electrode 225. The circuit interconnection lines 280 may be connected to the circuit contact plugs 270 and may be disposed in a plurality of layers. The circuit contact plugs 270 and the circuit interconnection lines 280 may include a conductive material, and may include, for example, tungsten (W), copper (Cu), and aluminum (Al), and each of the components may further include a diffusion barrier. In example embodiments, the number of layers of the circuit contact plugs 270 and the circuit interconnection lines 280 may be variously changed.

The second bonding vias 295 and the second bonding metal layers 298, and the second bonding insulating layer may be included in a second bonding structure, and may be disposed below a portion of lowermost circuit interconnection lines 280. The second bonding vias 295 may have a cylindrical shape, and the second bonding metal layers 298 may have a pad shape having a circular shape or a relatively short line shape in plan view. Lower surfaces of the second bonding metal layers 298 may be exposed to a lower surface of the second substrate structure PERI. The second bonding vias 295 and the second bonding metal layers 298 may provide an electrical connection path with the first semiconductor structure CELL. In example embodiments, some of the second bonding metal layers 298 may not be connected to the circuit interconnection lines 280 and may be disposed only for bonding. The second bonding vias 295 and the second bonding metal layers 298 may include a conductive material, and may include, for example, copper (Cu).

The second bonding insulating layer may be defined as a predetermined thickness from a lower surface of the peripheral region insulating layer 290, but may also be implemented as a separate insulating layer on the lower surface of the peripheral region insulating layer 290. The second bonding insulating layer may be a layer for dielectric-dielectric bonding with the first bonding insulating layer of the first semiconductor structure CELL. The second bonding insulating layer may also function as a diffusion barrier of the second bonding metal layers 298, and may include, for example, at least one of SiO, SiN, SiCN, SiOC, SiON, and SiOCN.

The first and second semiconductor structures CELL and PERI may be bonded to each other by bonding of the first bonding metal layers 198 and the second bonding metal layers 298 and bonding of the first bonding insulating layer and the second bonding insulating layer. The bonding of the first bonding metal layers 198 and the second bonding metal layers 298 may be, for example, copper (Cu)-copper (Cu) bonding, and the bonding of the first bonding insulating layer and the second bonding insulating layer may be, for example, dielectric-dielectric bonding, such as SiCN-SiCN bonding. The first and second semiconductor structures CELL and PERI may be bonded by hybrid bonding including copper (Cu)-copper (Cu) bonding and dielectric-dielectric bonding.

The first and second semiconductor structures CELL and PERI may be packaged in a form in which the first semiconductor structure CELL is disposed below the second semiconductor structure PERI, as illustrated in FIG. 11, or, alternatively, may be packaged in a form in which the second semiconductor structure PERI is disposed below the first semiconductor structure CELL, in a state in which an upper portion and a lower portion are reversed.

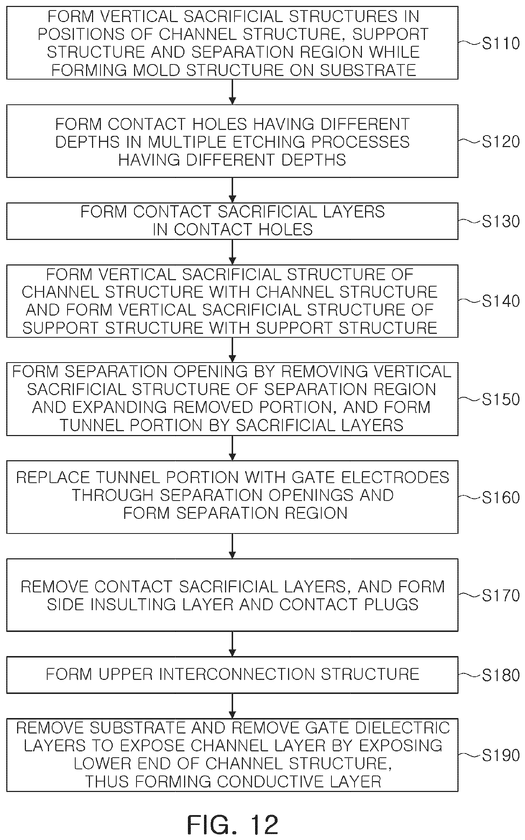

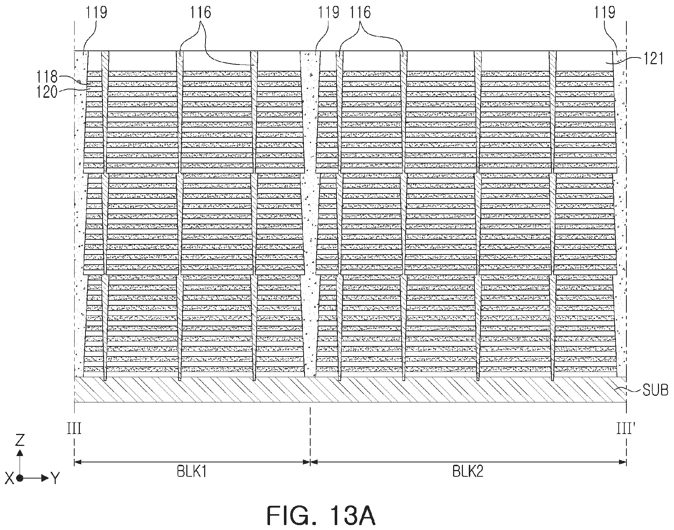

FIGS. 12 and 13A to 13J illustrate a method of manufacturing a semiconductor device according to example embodiments.

FIG. 12 is a flow chart showing a method of manufacturing a semiconductor device according to an example embodiment, FIGS. 13A to 13J are schematic cross-sectional views illustrating intermediate processes in a method of manufacturing a semiconductor device according to an example embodiment, FIGS. 13A to 13I illustrate cross-sections corresponding to FIG. 3C, and FIG. 13J illustrates a cross-section corresponding to FIG. 3A.

Specifically, referring to FIGS. 12 and 13A, sacrificial insulating layers 118 and interlayer insulating layers 120 may be alternately stacked in the Z-direction on a base substrate SUB, and may be formed up to an uppermost interlayer insulating layer 121. Vertical sacrificial structures 116 penetrating through (i.e., extending in) a mold structure may be formed (S110).

The base substrate SUB is a layer removed through a subsequent process, and may be a semiconductor substrate such as a silicon (Si) wafer. A first mold structure may be formed first and high aspect ratio contact (HARC) etching may be performed through the first mold structure, and a portion of the vertical sacrificial structures 116 may be formed, and then, a second mold structure may be formed and HARC etching may be performed through the second mold structure, and a portion of the vertical sacrificial structures 116 may be formed. In the same manner, third mold structures and a portion of the vertical sacrificial structures 116 may be formed.

The sacrificial insulating layers 118 may be a layer replaced with the gate electrodes 130 (see FIGS. 3A to 3C) through a subsequent process. The sacrificial insulating layers 118 may be formed of a different material from the interlayer insulating layers 120, and may be formed of a material that may be etched with etch selectivity under specific etching conditions with respect to the interlayer insulating layers 120. For example, the interlayer insulating layer 120 may be formed of at least one of silicon oxide and silicon nitride, and the sacrificial insulating layers 118 may be formed of a material other than the interlayer insulating layer 120 selected from silicon, silicon oxide, silicon carbide, and silicon nitride. In example embodiments, cross-sectional thicknesses (in the Z-direction) of the interlayer insulating layers 120 may not all be the same, and the uppermost interlayer insulating layer 121 may have a greater thickness than the other interlayer insulating layers 120. The thicknesses of the interlayer insulating layers 120 and the sacrificial insulating layers 118 and the number of films included in the interlayer insulating layers 120 and the sacrificial insulating layers 118 may be variously changed from those illustrated.

The vertical sacrificial structures 116 may be formed in positions corresponding to the channel structures CH of FIG. 3A and the support structures DH of FIGS. 3B and 3C. The vertical sacrificial structures 116 may be formed, for example, with the same size as the channel structures CH and the support structures DH. The vertical sacrificial structures 116 may include, for example, carbon (C), but the present disclosure is not limited thereto.

In this case, a plurality of separation sacrificial structures 119 may be formed along with the vertical sacrificial structures 116 in a region in which the separation region MS is disposed. Unlike the separation region MS (e.g., MSa and MSb in FIGS. 3A - 3C), a plurality of separation holes (i.e., openings) having a circular cross-section and spaced apart from each other, may be formed simultaneously when forming the channel holes, and the separation holes may be filled to form the separation sacrificial structures 119. The separation sacrificial structures 119 may include, for example, carbon (C), but the present disclosure is not limited thereto.

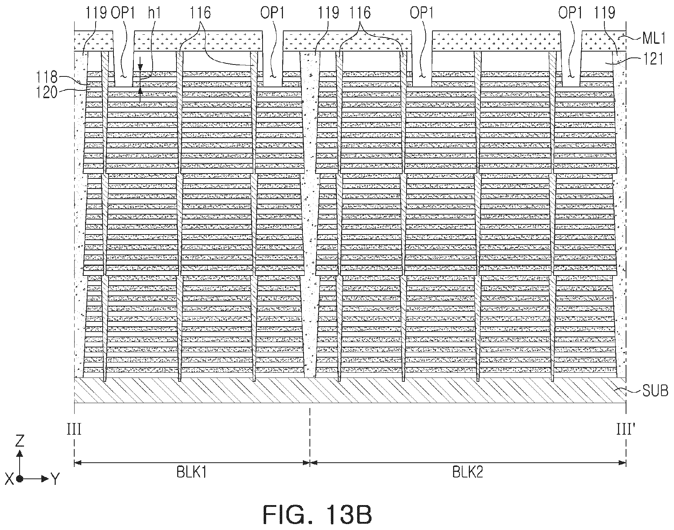

Referring to FIG. 12 and FIG. 13B to FIG. 13D, mask layers ML1 to ML3 may be formed on the uppermost interlayer insulating layer 121, through which multiple etchings may be performed, thus forming contact holes on different levels in the Z-direction, relative to an upper surface of the substrate SUB as a reference layer (S120).

The contact plugs MC1 and MC2 (see FIG. 2) of the semiconductor device 100 may have different lengths depending on the level of the gate electrode 130 in contact therewith. In order to form the contact plugs MC1 and MC2 having different lengths, contact holes (i.e., openings) OP1 to OP3 having corresponding depths may be formed in regions corresponding to each of the contact plugs MC1 and MC2. Each of the contact holes OP1 to OP3 may selectively apply a corresponding etching process, among multiple etching processes having different depths depending on a depth thereof.

The contact hole etching may form contact holes having different depths representing levels of each gate electrode 130 in the Z-direction in binary notation and exposing all gate electrodes 130 on all levels through an etching process of the same number of times as the number of digits as the binary notation.

In the semiconductor device 100 of FIG. 3B and FIG. 3C, contact holes OP1 to OP3 may be formed in which all gate electrodes 130 are exposed in a manner in which the sacrificial insulating layer 118 and the interlayer insulating layer 120 in the mold structure are etched five times.

Specifically, in first partial etching, the uppermost interlayer insulating layer 121 may be etched to expose the sacrificial insulating layer 118 corresponding to the gate electrode 130 of a first layer, and in second partial etching, etching may be performed to simultaneously remove the sacrificial insulating layers 118 and the interlayer insulating layers 120 corresponding to the gate electrodes 130 of a second layer. In third partial etching, etching may be performed to simultaneously remove the sacrificial insulating layers 118 and the interlayer insulating layers 120 corresponding to the gate electrodes 130 of a fourth layer. In fourth partial etching, etching may be performed to simultaneously remove the sacrificial insulating layers 118 and the interlayer insulating layers 120 corresponding to the gate electrodes 130 of an eighth layer, and in fifth partial etching, etching may be performed to simultaneously remove the sacrificial insulating layers 118 and the interlayer insulating layers 120 corresponding to the gate electrodes 130 of a sixteenth layer.

The sacrificial insulating layers 118 corresponding to the 30 gate electrodes 130 of the mold structure may be formed as contact holes OP1 to OP3 exposing all the gate electrodes 130 in the stack structure GS with a combination of the five partial etching processes.

For example, the contact hole OP that opens a twenty-ninth gate electrode 130 from an upper portion in the stack structure GS of each stage should penetrate through the gate electrodes 130 of 29 (16+8+4+1) layers, and the contact hole OP may be formed by applying the remaining partial etching processes except for the second partial etching process of penetrating through the sacrificial insulating layers 118 of two layers, among the five partial etching processes.

In the present disclosure, one stage is illustrated as including 10 layers of gate electrodes 130, but the present disclosure is not limited thereto, and the number of partial etchings may be varied depending on the total number of gate electrodes 130.

FIGS. 13B to 13D illustrate a process for manufacturing contact holes OP1 to OP3 forming the contact plugs MC1 and MC2 of FIG. 3C. The contact plugs MC2 in FIG. 3C are connected to tenth and twenty-sixth gate electrodes 130. In order to form the contact holes OP1 to OP3 of the contact plugs MC2 as described above, the partial etching processes of FIGS. 13B to 13D may be performed.

As illustrated in FIG. 13B, a first mask layer ML1 may be formed, and a first opening OP1 may be formed. The first mask layer ML1 may include a photoresist layer. The first openings OP1 may be formed in a circular shape, an oval shape, or shapes similar thereof in regions corresponding to the contact plugs MC2 of FIG. 3C. The first mask layer ML1 may be patterned, and the uppermost interlayer insulating layer 121 and the uppermost sacrificial insulating layer 118 and the interlayer insulating layer 120 therebelow may be removed accordingly to form first openings OP1. The first openings OP1 may extend further in the Z-direction from an upper surface of the uppermost sacrificial insulating layer 118 by a first depth h1.

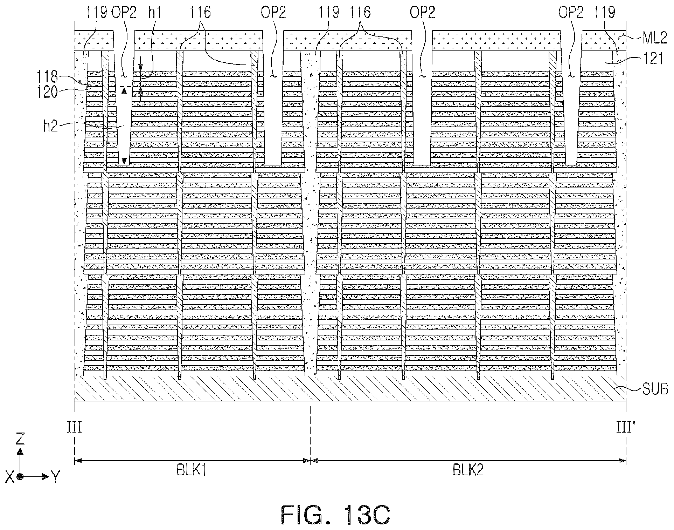

Referring to FIG. 13C, a second mask layer ML2 may be formed and the second openings OP2 may be formed. The second openings OP2 may be formed by etching the mold structure to further penetrate through eight layers of sacrificial insulating layers 118 and the interlayer insulating layers 120 therebelow in the first openings OP1 that are opened.

The second openings OP2 may extend in the Z-direction from a bottom of the first openings OP1 by a second depth h2. Accordingly, the second openings OP2 may expose an upper surface of a tenth sacrificial insulating layer 118 from an upper portion.

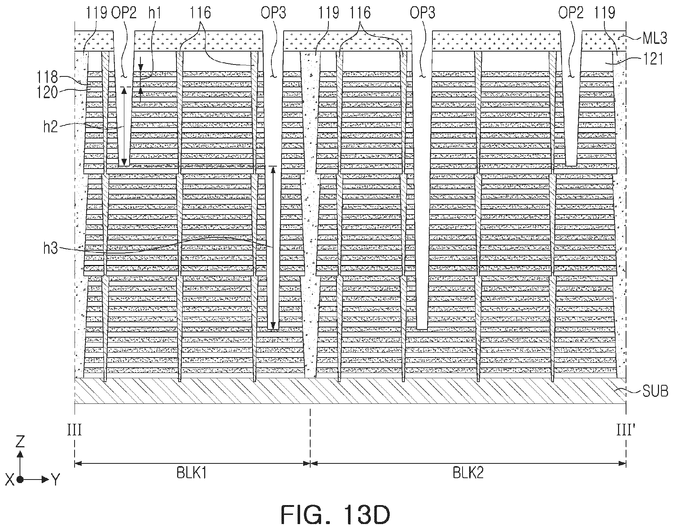

Next, referring to FIG. 13D, a third mask layer ML3 may be formed, and a third openings OP3 may be formed. The third openings OP3 may be formed by etching the mold structure to further penetrate 16 sacrificial insulating layers 118 and the interlayer insulating layers 120 therebelow in some of the second openings OP2 that are opened.

The third openings OP3 may further extend in the Z-direction from a bottom of the second openings OP2 by a third depth h3. Accordingly, the third opening OP3 may expose an upper surface of twenty-sixth sacrificial insulating layer 118 from the upper portion. By successively performing such partial etchings, the corresponding partial etchings may be selectively applied to each of the contact holes OP1 to OP3 to form the contact holes OP1 to OP3 having different depths.

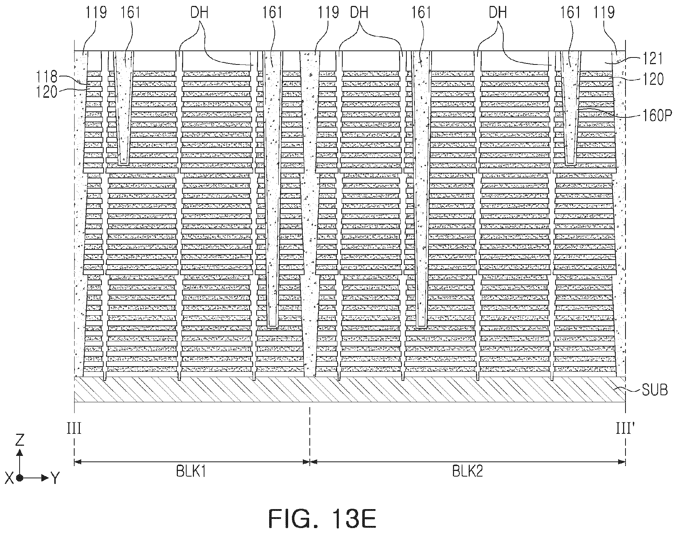

Referring to FIGS. 12 and 13E, preliminary contact insulating layers 160P and contact sacrificial layers 161 may be formed in the contact holes OP1 to OP3 (S130).

The preliminary contact insulating layers 160P may be conformally formed to cover sidewalls and bottom surfaces of the contact holes OP1 to OP3. For example, the preliminary contact insulating layers 160P may be formed using an atomic layer deposition (ALD) or chemical vapor deposition (CVD) process. The term "conformally" (or "conformal," or like terms), as may be used herein in the context of a material layer or coating, is intended to refer broadly to a material layer or coating having a substantially uniform cross-sectional thickness relative to the contour of a surface to which the material layer is applied.

The contact sacrificial layers 161 may be formed to fill the contact holes OP1 to OP3 on the preliminary contact insulating layers 160P. The contact sacrificial layers 161 may include a different material from the preliminary contact insulating layers 160P, and may include, for example, include carbon (C).

Referring to FIG. 12, a portion of the vertical sacrificial structures 116 may be removed to form channel structures CH (S140).

A mask layer exposing only a region corresponding to the channel structures CH in the cell region R1 (see FIG. 2) may be formed, and the exposed vertical sacrificial structures 116 may be removed to form channel holes. With reference to FIGS. 4A and 4B together, at least a portion of the channel dielectric layer 145, the channel layer 140, the channel buried insulating layer 147, and the channel pad 149 may be sequentially deposited in the channel holes, thus forming channel structures CH.

The channel dielectric layer 145 may be formed to have a uniform thickness using an ALD or CVD process. In the operation, all or a portion of the channel dielectric layer 145 may be formed, and a portion extending vertically along the channel structures CH to the conductive layer 101 may be formed in the operation. The channel layer 140 may be formed on the channel dielectric layer 145 in the channel holes. The channel buried insulating layer 147 may be formed to fill the channel holes and may be an insulating material. The channel pad 149 may be formed of a conductive material, and may be formed of, for example, polycrystalline silicon.

Additionally, a portion of the vertical sacrificial structures 116 may be removed to form support structures DH.

A mask layer exposing a region corresponding to the support structures DH in the string selection region R1b and the extension region R2 may be formed, and dummy holes may be formed by removing the exposed vertical sacrificial structures 116. A process of expanding the dummy holes by partially removing the mold structure around the dummy holes may be performed. The expanded dummy holes may be filled with an insulating material to form the support structures DH. The term "filled" (or "filling," or like terms) is intended to refer to either completely filling a defined space (e.g., the space between adjacent mold insulating films 120) or partially filling the defined space; that is, the defined space need not be entirely filled but may, for example, be partially filled or have voids or other spaces throughout.

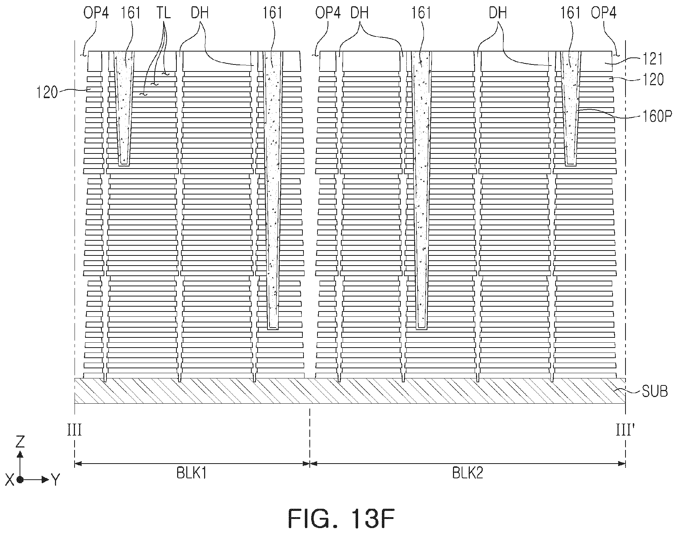

Referring to FIG. 12 and FIG. 13F, the sacrificial insulating layers 118 may be removed (S150).

A separation opening OP4 that opens a region corresponding to the separation regions MS (MSa and MSb of FIG. 3A) of FIG. 13F may be formed. The separation opening OP4 may be formed by removing all of the separation sacrificial structures 119 (see FIG. 13E) in a state of exposing the plurality of separation sacrificial structures 119 to form vertical holes, and then expanding a plurality of vertical holes through a cleaning process or the like, to connect the expanded vertical holes with adjacent vertical holes. When the separation opening OP4 is formed by expanding the plurality of vertical holes, side surfaces of the separation opening OP4 may include convex curved surfaces continuously, but the present disclosure is not limited thereto.

In this case, the separation opening OP4 may be formed such that a region corresponding to the first separation regions MSa extends straight in the X-direction, as in the shape of the separation regions MS of FIG. 2 and FIG. 3A to FIG. 3C, and a region corresponding to the second separation regions MSb may be formed to include bend portions S4 and S5.

The sacrificial insulating layers 118 exposed through the separation openings OP4 may be removed. The sacrificial insulating layers 118 may be selectively removed, for example, using wet etching, with respect to the interlayer insulating layers 120, the channel structures CH, the support structures DH, and the preliminary contact insulating layers 160P, thus forming tunnel portions TL.

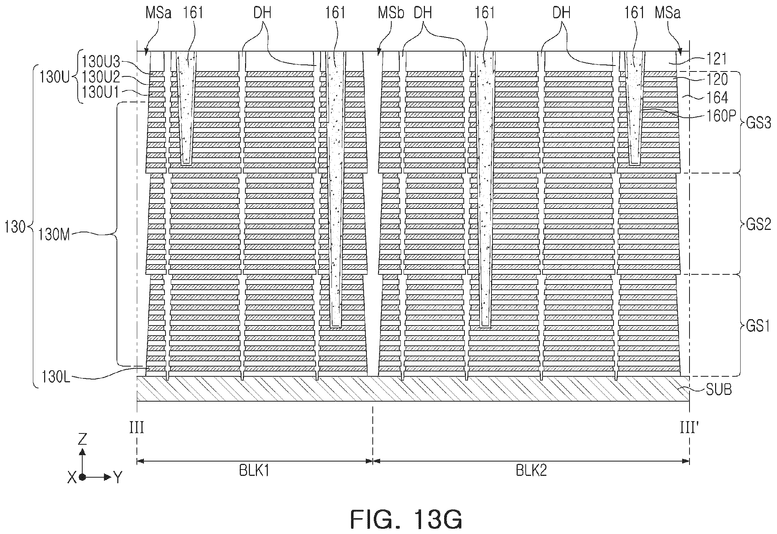

Referring to FIG. 12 and FIG. 13G, gate electrodes 130 may be formed (S160). The gate electrodes 130 may be formed by depositing a conductive material in regions from which the sacrificial insulating layers 118 are removed through the separation openings OP4. The conductive material may include a metal, polycrystalline silicon, or a metal silicide material. In the gate electrodes 130, after forming the diffusion barriers 131 (see FIG. 4A), the gate electrodes 130 may be formed by depositing a conductive material. In some example embodiments, a portion of the channel dielectric layer 145 may be formed before forming the gate electrodes 130. As a result, the stack structure GS including the first to third stack structures GS1 to GS3 may be formed. After forming the gate electrodes 130, an insulating material may be deposited in the separation openings OP4, thus forming first and second separation regions MSa and MSb extending in the X-direction as illustrated in FIG. 2. Then, first and second insulating regions SS1 and SS2 penetrating through the upper gate electrodes 130U1 to 130U3 may be formed.

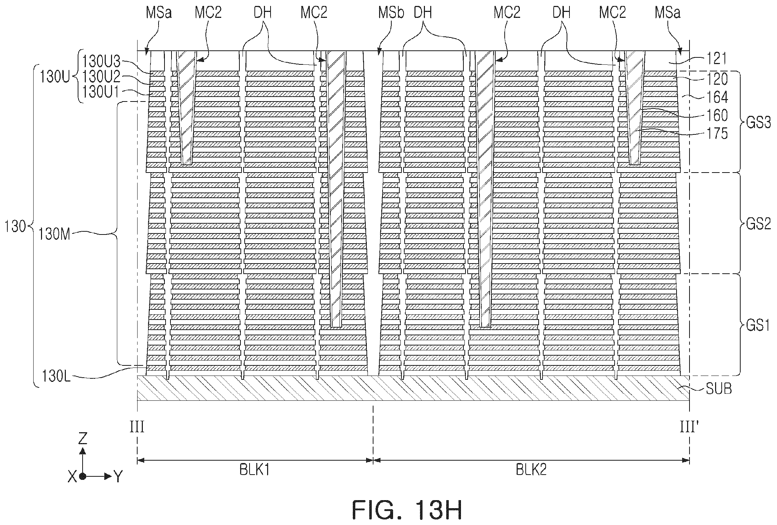

Referring to FIGS. 12 and 13H, contact plugs MC1 and MC2 may be formed (S170). Specifically, after the contact sacrificial layers 161 are selectively removed with respect to the preliminary contact insulating layers 160P, some of the exposed preliminary contact insulating layers 160P may be removed to form contact insulating layers 160.

That is, after the contact sacrificial layers 161 are removed, some of the exposed preliminary contact insulating layers 160P may be removed from bottom surfaces. When the preliminary contact insulating layers 160P are removed, some of the exposed gate electrodes 130 may also be recessed from upper surfaces. Accordingly, the contact insulating layers 160 disposed only on sidewalls of the first to third openings OP1 to OP3 may be formed. The contact plugs MC1 and MC2 may be formed by depositing a conductive material in the first to third openings OP1 to OP3. The contact plugs MC1 and MC2 may be physically connected to the gate electrodes 130 assigned downwardly, respectively.

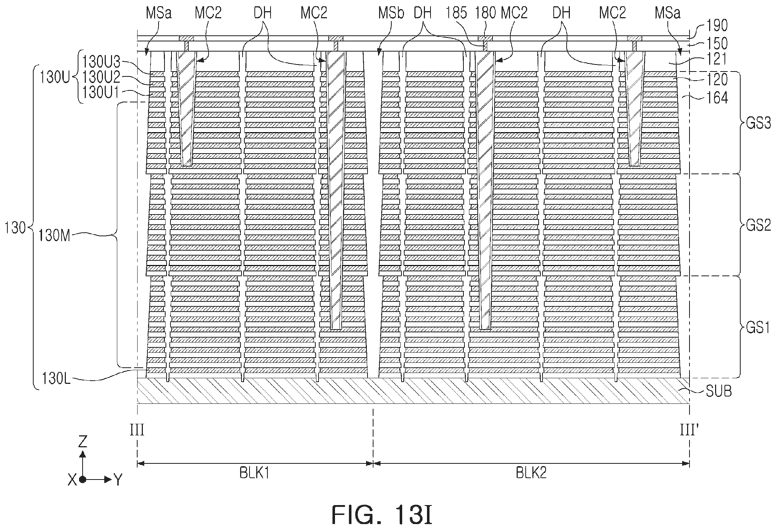

Referring to FIG. 12 and FIG. 13I, upper interconnection structures (studs 185 and lines 180) may be formed on the stack structures GS1 to GS3 (S180).

After forming the cell region insulating layer 150, the studs 185 and the cell interconnection lines 180 may be formed.

The studs 185 may be formed by forming stud holes penetrating through the cell region insulating layer 150 to expose the channel structures CH and the contact plugs MC1 and MC2, and then filling the stud holes with a conductive material. The cell interconnection lines 180 may be formed on the studs 185. An upper insulating layer 190 may be further formed on the cell interconnection lines 180, and a bonding structure for bonding with the second semiconductor structure of FIG. 11 may also be formed together.

Referring to FIG. 12 and FIG. 13J, the base substrate SUB may be removed, and the channel layers 140 may be exposed (S190).

The base substrate SUB may be removed, and a portion of the exposed channel dielectric layers 145 (see FIG. 4A) may be removed, thereby exposing the channel layers 140.

Next, referring to FIG. 3A together, the semiconductor device 100 of FIG. 3A may be manufactured by forming a conductive layer 101 connected to the channel layers 140. In some example embodiments, the conductive layer 101 may be formed as a conformal layer along upper ends of the channel structures CH and upper ends of the support structures DH.

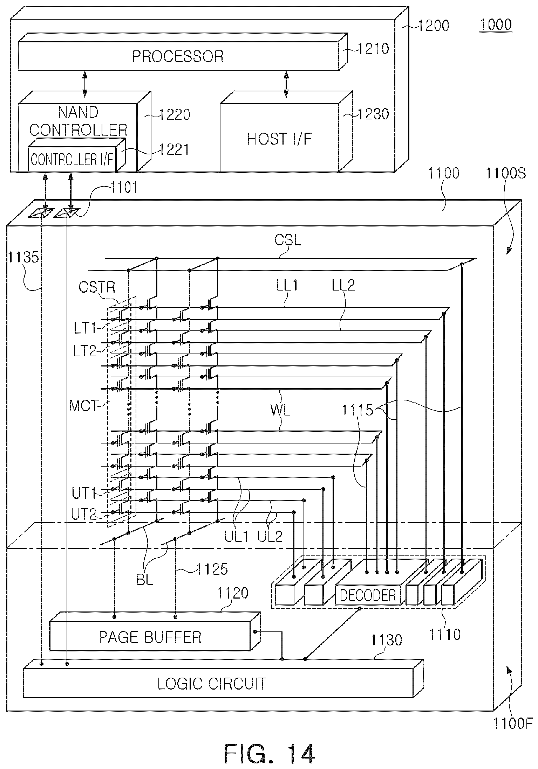

FIG. 14 is a schematic diagram illustrating a data storage system including a semiconductor device according to example embodiments.

Referring to FIG. 14, a data storage system 1000 may include a semiconductor device 1100 and a controller 1200 electrically connected to the semiconductor device 1100. The data storage system 1000 may be a storage device including one or more semiconductor devices 1100 or an electronic device including the storage device. For example, the data storage system 1000 may be a solid state drive device (SSD), a Universal Serial Bus (USB), a computing system, a medical device, or a communication device, including one or more semiconductor devices 1100.

The semiconductor device 1100 may be a nonvolatile memory device, and may be, for example, a NAND flash memory device as described above with reference to FIGS. 1 to 11. The semiconductor device 1100 may include a first structure 1100F and a second structure 1100S on the first structure 1100F. In example embodiments, the first structure 1100F may be disposed next to the second structure 1100S. The first structure 1100F may be a peripheral circuit structure including a decoder circuit 1110, a page buffer 1120, and a logic circuit 1130. The second structure 1100S may be a memory cell structure including one or more bit lines BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be variously changed depending on example embodiments.

In example embodiments, the upper transistors UT1 and UT2 may include string select transistors, and the lower transistors LT1 and LT2 may include ground selection transistors. The gate lower lines LL1 and LL2 may be gate electrodes of the lower transistors LT1 and LT2, respectively. The word lines WL may be gate electrodes 130 of the memory cell transistors MCT, and the gate upper lines UL1 and UL2 may be gate electrodes of the upper transistors UT1 and UT2, respectively.

In example embodiments, the lower transistors LT1 and LT2 may include lower erase control transistors LT1 and ground selection transistors LT2 serially connected. The upper transistors UT1 and UT2 may include a string select transistor UT1 and an upper erase control transistor UT2 serially connected. At least one of the lower erase control transistor LT1 and the upper erase control transistor UT2 may be used for an erase operation of erasing data stored in the memory cell transistors MCT by utilizing a gate-induced drain leakage (GIDL) phenomenon.

The common source line CSL, the first and second gate lower lines LL1 and LL2, the word lines WL, and the first and second gate upper lines UL1 and UL2 may be electrically connected to the decoder circuit 1110 through first connecting interconnections 1115 extending from the first structure 1100F to the second structure 1100S. The bit lines BL may be electrically connected to the page buffer 1120 through second connection interconnections 1125 extending from the first structure 1100F to the second structure 1100S.

In the first structure 1100F, the decoder circuit 1110 and the page buffer 1120 may perform a control operation for at least one selected memory cell transistor, among the plurality of memory cell transistors MCT. The decoder circuit 1110 and the page buffer 1120 may be controlled by the logic circuit 1130. The semiconductor device 1100 may communicate with the controller 1200 through one or more input/output pads 1101 electrically connected to the logic circuit 1130. The input/output pad 1101 may be electrically connected to the logic circuit 1130 via a corresponding input/output connection interconnection 1135 extending from the first structure 1100F to the second structure 1100S.

The controller 1200 may include a processor 1210, a NAND controller 1220, and a host interface (I/F) 1230. According to example embodiments, the data storage system 1000 may include a plurality of semiconductor devices 1100, and in this case, the controller 1200 may control the plurality of semiconductor devices 1100.

The processor 1210 may control an overall operation of the data storage system 1000 including the controller 1200. The processor 1210 may operate according to a predetermined firmware, and may control the NAND controller 1220 to access the semiconductor device 1100. The NAND controller 1220 may include a controller interface 1221 configured to process communication with the semiconductor device 1100. Through the controller interface 1221, control commands for controlling the semiconductor device 1100, data to be written to the memory cell transistors MCT of the semiconductor device 1100, data to be read from the memory cell transistors MCT of the semiconductor device 1100, or the like, may be transmitted. The host interface 1230 may provide a communication function between the data storage system 1000 and an external host (not explicitly shown). When a control command is received from an external host through the host interface 1230, the processor 1210 may control the semiconductor device 1100 in response to the control commands.

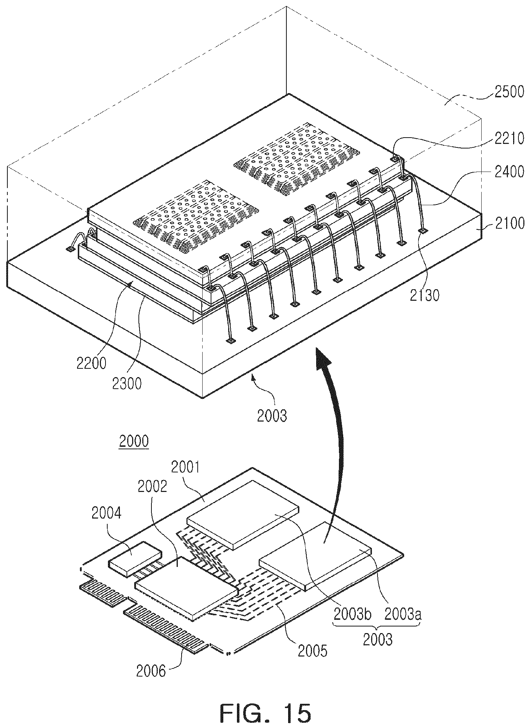

FIG. 15 is a perspective view schematically illustrating a data storage system including a semiconductor device according to an example embodiment.

Referring to FIG. 15, a data storage system 2000 may include a main board 2001, a controller 2002 mounted on the main board 2001, one or more semiconductor packages 2003, and a DRAM 2004. The semiconductor package 2003 and the DRAM 2004 may be connected to the controller 2002 by interconnection patterns 2005 formed on the main board 2001.

The main board 2001 may include a connector 2006 including a plurality of pins coupled to the external host. The number and arrangement of the plurality of pins in the connector 2006 may be variously changed depending on a communication interface between the data storage system 2000 and the external host. In example embodiments, the data storage system 2000 may communicate with the external host according to any one of interfaces such as Universal Serial Bus (USB), Peripheral Component Interconnect Express (PCI-Express), Serial Advanced Technology Attachment (SATA), and M-Phy for Universal Flash Storage (UFS). In example embodiments, the data storage system 2000 may operate by power supplied from the external host through a connector 2006. The data storage system 2000 may further include a Power Management Integrated Circuit (PMIC) configured to distribute the power supplied from the external host to the controller 2002 and the semiconductor package 2003.

The controller 2002 may write data to the semiconductor package 2003 or read data from the semiconductor package 2003, and may improve the operating speed of the data storage system 2000.

The DRAM 2004 may be a buffer memory for mitigating a speed difference between the semiconductor package 2003, which is a data storage space, and the external host. The DRAM 2004 included in the data storage system 2000 may also function as a kind of cache memory, and may also provide a space for temporarily storing data in a control operation for the semiconductor package 2003. When the data storage system 2000 includes the DRAM 2004, the controller 2002 may further include a DRAM controller for controlling the DRAM 2004 in addition to a NAND controller for controlling the semiconductor package 2003.

The semiconductor package 2003 may include first and second semiconductor packages 2003a and 2003b spaced apart from each other. The first and second semiconductor packages 2003a and 2003b may each be a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of each of the semiconductor chips 2200, a connection structure 2400 electrically connecting the semiconductor chips 2200 and the package substrate 2100, and a molding layer 2500 covering the semiconductor chips 2200 and the connection structure 2400 on the package substrate 2100.

The package substrate 2100 may be a printed circuit board including package upper pads 2130. Each semiconductor chip 2200 may include an input/output pad 2210. The input/output pad 2210 may correspond to the input/output pad 1101 of FIG. 14. Each of the semiconductor chips 2200 may include the semiconductor device described above with reference to FIGS. 1 to 11.

In example embodiments, the connection structure 2400 may be a bonding wire electrically connecting the input/output pad 2210 and the package upper pads 2130. Accordingly, in each of the first and second semiconductor packages 2003a and 2003b, the semiconductor chips 2200 may be electrically connected to each other in a bonding wire manner, and may be electrically connected to the package upper pads 2130 of the package substrate 2100. According to example embodiments, in each of the first and second semiconductor packages 2003a and 2003b, the semiconductor chips 2200 may be electrically connected to each other by a connection structure including a through-silicon via (TSV), instead of a bonding wire type connection structure 2400.

In example embodiments, the controller 2002 and the semiconductor chips 2200 may be included in one package. In an example embodiment, the controller 2002 and the semiconductor chips 2200 may be mounted on an additional interposer substrate different from the main board 2001, and the controller 2002 and the semiconductor chips 2200 may be connected to each other by interconnections formed on the interposer substrate.

**Claims**

1. A semiconductor device (100), comprising:

   a conductive layer (101);
   a stack structure (GS) including gate electrodes (130) spaced apart from each other and sequentially stacked in a first direction (Z), perpendicular to an upper surface of the conductive layer (101), in a first region (R1) and a second region (R2), adjacent to the first region (R1);
   a first separation region (MSa) and a second separation region (MSb) extending in the first direction (Z) through the stack structure (GS), along the second region (R2) from the first region (R1), and extending in a second direction (X), parallel to the upper surface of the conductive layer (101) and perpendicular to the first direction (Z), and spaced apart from each other in a third direction (Y), perpendicular to the first direction (Z) and the second direction (X);
   channel structures (CH), each of the channel structures (CH) including a channel layer (140) and extending through the stack structure (GS) in the first direction (Z), in the first region (R1); and
   contact plugs (MC) extending in the first direction (Z) by different lengths through at least one of the gate electrodes (130) of the stack structure (GS), electrically connected to each of the gate electrodes (130), and spaced apart from each other, in the second region (R2),
   wherein the second region (R2) includes:

      a first extension region (R2b) in which a distance in the third direction (Y) between the first separation region (MSa) and the second separation region (MSb) has a second distance (L2) greater than a first distance (L1) in the third direction (Y) between the first separation region (MSa) and the second separation region (MSb) in the first region (R1); and
      a second extension region (R2a) in which a distance in the third direction (Y) between the first separation region (MSa) and the second separation region (MSb) has a third distance (L3) smaller than the first distance (L1).

2. The semiconductor device (100) of claim 1,
   wherein the first extension region (R2b) and the second extension region (R2a) are successively arranged in the second direction (X).

3. The semiconductor device (100) of claim 1 or 2,
   wherein the second region (R2) includes a basic portion (Aa) having the third distance (L3) in the third direction (Y), and includes an expansion portion (Ab) extending from the basic portion (Aa) in the third direction (Y) in the first extension region (R2b).

4. The semiconductor device (100) of claim 3,

   wherein in the basic portion (Aa), the contact plugs (MC) are spaced apart from each other by a first separation distance (d1) or more to form rows and columns, and
   in the expansion portion (Ab), the contact plugs (MC) are arranged to form a row having a smaller number of contact plugs (MC) than a number of contact plugs (MC) in one row of the basic portion (Aa).

5. The semiconductor device (100) of claim 4,
   wherein in the expansion portion (Ab), a distance between the second separation region (MSb) and a contact plug (CH) closest to the second separation region (MSb) of the contact plugs (MC) is smaller than the first separation distance (d1).

6. The semiconductor device (100) of claim 4 or 5,
   wherein the contact plugs (MC) in the expansion portion (Ab) are spaced apart from each other by the first separation distance (d1) or more.

7. The semiconductor device (100) of any one of claims 3 to 6,

wherein about one-half of the contact plugs (MC) of one row in the basic portion form one row in the expansion portion (Ab).

8. The semiconductor device (100) of any one of claims 3 to 7,
wherein the first separation region (MSa) continuously extends in the second direction (X), and the second separation region (MSb) includes discontinuous portions extending in the second direction (X) and includes bend portions connecting the discontinuous portions in the expansion portion (Ab).

9. The semiconductor device (100) of any one of claims 3 to 8,
wherein in the basic portion (Aa), the contact plugs (MC) are arranged in a regular hexagonal shape, a square shape, or a diamond shape.

10. The semiconductor device (100) of any one of claims 3 to 9,
wherein the contact plugs (MC) are arranged in at least two rows in the expansion portion (Ab).

11. The semiconductor device (100) of any one of claims 3 to 10,
wherein a sum of the contact plugs (MC) in the expansion portions (Ab) arranged in the second direction (X) is a natural multiple of a first number of the contact plugs (MC) of the respective basic portions (Aa).

12. The semiconductor device (100) of any one of claims 1 to 11,

wherein each of the contact plugs (MC) includes a plug conductive layer (175) and a contact barrier layer (172) on a side surface and a lower surface of the plug conductive layer (175), and
further including a side insulating layer (160) extending around side surfaces of the contact plugs (MC) between the stack structure (GS) and the contact barrier layer (172).

13. The semiconductor device (100) of any one of claims 1 to 12,
wherein the second separation region (MSb) includes:

a first horizontal portion (S1) spaced apart from the first separation region (MSa) by the first distance (L1) and extending in the second direction (X), in the first region (R1);
a second horizontal portion (S2) spaced apart from the first separation region (MSa) by the second distance (L2) and extending in the second direction (X), in the first extension region (R2b);
a third horizontal portion (S3) spaced apart from the first separation region (MSa) by the third distance (L3) and extending in the second direction (X), in the second extension region (R2a);
a first bend portion (S4) configured to connect the first horizontal portion (S1) and the second horizontal portion (S2); and
a second bend portion (S5) configured to connect the second horizontal portion (S2) and the third horizontal portion (S3).

14. The semiconductor device (100) of claim 13,
wherein a length of the first bend portion (S4) is shorter than a length of the second bend portion (S5).

15. A data storage system (1000, 2000), comprising:

a semiconductor storage device including a first semiconductor structure (CELL) including circuit elements (220), a second semiconductor structure (PERI) on one surface of the first semiconductor structure (CELL) corresponding to the semiconductor device (100) of any one of claims 1 to 12, and an input/output pad (1101, 2210) electrically connected to the circuit elements (220); and
a controller (1220, 2002) electrically connected to the semiconductor storage device through the input/output pad (1101, 2210) and controlling the semiconductor storage device.

MAT

FIG. 1

FIG. 2

EP 4 686 337 A1

FIG. 3A

FIG. 3B

FIG. 3C

100

B

FIG. 4A

100

C

FIG. 4B

<u>100</u>

190 — — 180
— 185
150 —
— 160
— 172 ⎫ MC2
— 175 ⎭
— 121
— 130U3 ⎫
— 130U2 ⎬ 130U
120 —
— 130U1 ⎭

— 130 ⎫

— 130M

— 130 ⎭

<u>D</u>

FIG. 4C

FIG. 5

FIG. 6

FIG. 7

EP 4 686 337 A1

FIG. 8

FIG. 9

FIG. 10

FIG. 11

EP 4 686 337 A1

FORM VERTICAL SACRIFICIAL STRUCTURES IN POSITIONS OF CHANNEL STRUCTURE, SUPPORT STRUCTURE AND SEPARATION REGION WHILE FORMING MOLD STRUCTURE ON SUBSTRATE — S110

FORM CONTACT HOLES HAVING DIFFERENT DEPTHS IN MULTIPLE ETCHING PROCESSES HAVING DIFFERENT DEPTHS — S120

FORM CONTACT SACRIFICIAL LAYERS IN CONTACT HOLES — S130

FORM VERTICAL SACRIFICIAL STRUCTURE OF CHANNEL STRUCTURE WITH CHANNEL STRUCTURE AND FORM VERTICAL SACRIFICIAL STRUCTURE OF SUPPORT STRUCTURE WITH SUPPORT STRUCTURE — S140

FORM SEPARATION OPENING BY REMOVING VERTICAL SACRIFICIAL STRUCTURE OF SEPARATION REGION AND EXPANDING REMOVED PORTION, AND FORM TUNNEL PORTION BY SACRIFICIAL LAYERS — S150

REPLACE TUNNEL PORTION WITH GATE ELECTRODES THROUGH SEPARATION OPENINGS AND FORM SEPARATION REGION — S160

REMOVE CONTACT SACRIFICIAL LAYERS, AND FORM SIDE INSULTING LAYER AND CONTACT PLUGS — S170

FORM UPPER INTERCONNECTION STRUCTURE — S180

REMOVE SUBSTRATE AND REMOVE GATE DIELECTRIC LAYERS TO EXPOSE CHANNEL LAYER BY EXPOSING LOWER END OF CHANNEL STRUCTURE, THUS FORMING CONDUCTIVE LAYER — S190

FIG. 12

FIG. 13A

FIG. 13B

FIG. 13C

FIG. 13D

EP 4 686 337 A1

FIG. 13E

EP 4 686 337 A1

OP4 161 TL DH 161 OP4 DH 161 DH 161 OP4

121

120

160P

120

SUB

III III'

Z
X Y

BLK1 BLK2

FIG. 13F

FIG. 13G

FIG. 13H

FIG. 13I

EP 4 686 337 A1

FIG. 13J

EP 4 686 337 A1

FIG. 14

FIG. 15

Europäisches
Patentamt

European
Patent Office

Office européen
des brevets

# EUROPEAN SEARCH REPORT

**Application Number**

EP 25 17 7510

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 2021 0101979 A (SAMSUNG ELECTRONICS CO LTD [KR]) 19 August 2021 (2021-08-19) * paragraph [0007] - paragraph [0062] * * figures 1-9 * | 1-15 | INV. H10B41/10 H10B41/27 H10B41/50 H10B43/10 H10B43/27 H10B43/50 |
| X | US 2024/071918 A1 (XU LIFANG [US] ET AL) 29 February 2024 (2024-02-29) * paragraph [0050] - paragraph [0073] * * pages 1, 2 * | 1-3,8, 12-15 | |
| X | US 2023/232632 A1 (KIM JUNHYOUNG [KR] ET AL) 20 July 2023 (2023-07-20) * paragraph [0041] - paragraph [0085] * * figures 1-5, 10-12 * | 1-15 | |

**TECHNICAL FIELDS SEARCHED (IPC)**

H10B

The present search report has been drawn up for all claims

| Place of search | Date of completion of the search | Examiner |
|---|---|---|
| Munich | 31 October 2025 | Bruckmayer, Manfred |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
..................................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 17 7510

This annex lists the patent family members relating to the patent documents cited in the above-mentioned European search report.
The members are as contained in the European Patent Office EDP file on
The European Patent Office is in no way liable for these particulars which are merely given for the purpose of information.

31-10-2025

| Patent document cited in search report | Publication date | Patent family member(s) | Publication date |
|---|---|---|---|
| KR 20210101979 A | 19-08-2021 | NONE | |
| US 2024071918 A1 | 29-02-2024 | CN 117641929 A | 01-03-2024 |
| | | US 2024071918 A1 | 29-02-2024 |
| US 2023232632 A1 | 20-07-2023 | CN 112234064 A | 15-01-2021 |
| | | KR 20210008985 A | 26-01-2021 |
| | | US 2021020656 A1 | 21-01-2021 |
| | | US 2023232632 A1 | 20-07-2023 |

EPO FORM P0459

For more details about this annex : see Official Journal of the European Patent Office, No. 12/82